# EUROPEAN PATENT APPLICATION

(11) **EP 4 658 036 A1**
(43) Date of publication of application: **03.12.2025**
(21) Application number: 25178504.4
(22) Date of filing: 23.05.2025
(51) Int. Cl.: H10H 29/01, H10H 29/03, H10H 29/30, H01L 21/683, H01L 23/00

(54) **DEVICE FOR MANUFACTURING A DISPLAY PANEL**

(30) Priority: 27.05.2024 KR 20240068297
(71) Applicant: Samsung Display Co., Ltd., Yongin-si, Gyeonggi-do 17113 (KR)
(72) Inventor: Han, Jeong Won, Yongin-si, Gyeonggi-do (KR)
(74) Representative: Gulde & Partner

(57) **Abstract**

A device for manufacturing a display panel includes a support portion (200) on which a display substrate (20) is mounted. The device includes a light transmitting plate (310) disposed on a front surface of the support portion (200), a reflective member (330) disposed within the light transmitting plate (310), and a light absorbing member (340) configured to absorb laser light reflected by the reflective member (330). The device includes a pressing portion (300) configured to move the light transmitting plate (310) toward the display substrate (20) in association with pressing a plurality of light emitting elements (LE) arranged on the display substrate (20) with the light transmitting plate (310). The device includes a laser emission portion (500) disposed on a front side of the light transmitting plate (310) and configured to irradiate the display substrate (20) with laser light through the light transmitting plate (310).

## Description

### BACKGROUND

### 1. Field

The present disclosure relates to a device for manufacturing a display panel.

### 2. Description of the Related Art

Micro LED is an ultra-small inorganic light emitting material that emits light on its own without a backlight. Specifically, micro LED are about one-tenth the length and one-hundredth the area of organic light emitting diode chips. In one example, micro LED may refer to an ultra-small LED whose width, length, and height in the range of about 10 micrometers (µm) to 100 µm.

Micro LED may be manufactured by growing a plurality of chips in the form of chips on a growth substrate such as, for example, a wafer through an epi process or the like. In some cases, a micro LED manufactured in this way may be transferred to a relay substrate and then transferred to a target substrate such that the micro LED may be used as a display module.

The transfer process of the micro LED may use a laser transfer method that transfers the micro LED of the relay substrate to the target substrate by irradiating, with a laser beam, the back of the relay substrate (a plurality of micro LED are arranged on the front of the relay substrate).

However, the laser transfer method suffers from the problem that the laser beam emitted for irradiating the back of the relay substrate also passes through the areas between the micro-LED and to the outer areas of the relay substrate, thereby irradiating the target substrate in addition to the micro-LED. In an example in which the laser beam is applied to the target substrate, the temperature of the target substrate increases and damage occurs.

### SUMMARY

Aspects and features of embodiments of the present disclosure provide a device for manufacturing a display panel that reflects a laser beam incident a surrounding area other than the micro-LED such that the laser beam may accurately be applied to the micro-LED without being applied to other components, while increasing the uniformity of the pressing force generated by the pressing of the laser light emitting member.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an embodiment, a device for manufacturing a display panel includes a support portion on which a display substrate is mounted, a light transmitting plate disposed on a front surface of the support portion, a reflective member disposed within the light transmitting plate, and a light absorbing member configured to absorb laser light reflected by the reflective member, a pressing portion configured to move the light transmitting plate toward the display substrate in association with pressing a plurality of light emitting elements arranged on the display substrate with the light transmitting plate and a laser emission portion disposed on a front side of the light transmitting plate and configured to irradiate the display substrate with laser light through the light transmitting plate, wherein the reflective member includes a first reflective member defining an opening corresponding to a transmission area of the laser light, and a second reflective member configured to guide light reflected from the first reflective member to the light absorbing member.

The reflective member may further include a third reflective member disposed between the second reflective member and the light absorbing member, wherein the third reflective member may be configured to reflect laser light reflected from the second reflective member to the light absorbing member.

The first reflective member, the second reflective member, and the third reflective member may be embedded in an outer area of the light transmitting plate corresponding to a non-display area, which may be an outer area of the display substrate, excluding a display area of the display substrate on which the plurality of light emitting elements are arranged, and may be arranged in order from inside of the light transmitting plate toward an outside of the light transmitting plate.

The first reflective member may be formed in the shape of a triangular mountain having a triangular cross-section, and the triangular cross-section may be formed as one of a right triangle, an equilateral triangle, and an isosceles triangle, and one of front surfaces of the first reflective member may have a preset inclination in the direction in which the second reflective member is disposed.

The light transmitting plate may include a first inner surface and a second inner surface facing the first inner surface, wherein the first reflective member and the third reflective member may be disposed on the first inner surface, and the second reflective member may be disposed on the second inner surface.

The light absorbing member may be disposed on a side of the light transmitting plate and may be disposed in a reflection path of the laser light.

The opening may be formed in an area corresponding to a non-display area, which may be an outer area of the display substrate.

The pressing portion may include a plate transfer portion that is coupled to the light transmitting plate and may be configured to move in a direction toward to the display substrate or in an opposite direction away from the display substrate.

The light transmitting plate may be configured to transmit laser light incident the light transmitting plate, from: a front of the light transmitting plate to a back of the light transmitting plate in a first direction; or from the back to the front or back in a second direction opposite the first direction, may be formed in a form of a transparent or translucent flat plate, may be movable by the plate transfer portion in a direction toward to the display substrate or in an opposite direction away from the display substrate, and may be movable in the direction toward the display substrate by the plate transfer portion in association with pressing a plurality of light emitting elements arranged on the display substrate in the direction toward the display substrate.

According to an embodiment, a device for manufacturing a display panel includes a support portion on which a display substrate is mounted, a pressing portion including a light transmitting plate disposed on the front surface of the support portion, a reflective member disposed within the light transmitting plate, a light absorbing member configured to absorb laser light reflected by the reflective member, and a pressing member configured to press the light transmitting plate and a laser emission portion disposed in front of the pressing portion and configured to emit laser light through the light transmitting plate and irradiate the display substrate with the laser light, wherein the pressing member includes, a first light transmitting member disposed on the light transmitting plate, a second light transmitting member disposed on the light transmitting plate, and a gas pressure adjustment portion configured to generate a pressing force on the light transmitting plate by adjusting gas pressure in a closed space formed between the first light transmitting member and the second light transmitting member.

The first light transmitting member may be formed of a rigid material, wherein the second light transmitting member may be formed of an elastic material.

The second light transmitting member may be arranged such that the second light transmitting member overlaps the first light transmitting member in a thickness direction.

The device may further include a gas conduit connected between the gas pressure adjustment portion and the closed space.

The device may further include a buffering member disposed between the light transmitting plate and the pressing member.

The reflective member may be formed in the shape of a triangular mountain having a triangular cross-section, and the triangular cross-section may be formed as one of a right triangle, an equilateral triangle, and an isosceles triangle, wherein a front surface of the reflective member may be inclined at a preset inclination in a direction in which the light absorbing member is disposed.

The reflective member may be attached to or mounted on an outer area of the light transmitting plate corresponding to a non-display area, which may be an outer area of the display substrate, excluding a display area of the display substrate where a plurality of light emitting elements are arranged.

The light absorbing member may be disposed between the laser emission portion and the pressing portion and may not overlap a light path associated with the laser light emitted by the laser emission portion.

The light absorbing member may be disposed in the closed space and may not overlap a light path associated with the laser light emitted by the laser emission portion.

The reflective member may include a first reflective member defining an opening corresponding to a transmission area of the laser light, and a second reflective member configured to guide light reflected from the first reflective member to the light absorbing member.

According to an embodiment, a device for manufacturing a display panel includes a support portion on which a display substrate is mounted, a pressing portion including a light transmitting plate disposed in front of the support portion, a light absorbing member configured to absorb laser light, and a pressing member configured to press the light transmitting plate and a laser emission portion disposed in front of the pressing portion and configured to emit laser light through the light transmitting plate and irradiate the display substrate with the laser light, wherein the pressing member includes, a first light transmitting member disposed on the light transmitting plate, a second light transmitting member disposed on the light transmitting plate, and a reflective member disposed within the light transmitting plate and configured to reflect incident laser light to the light absorbing member and a gas pressure adjustment portion configured to generate a pressing force on the light transmitting plate by adjusting gas pressure in a closed space formed between the first light transmitting member and the second light transmitting member.

The light absorbing member may be disposed between the laser emission portion and the first light transmitting member and may not overlap a light path associated with the laser light emitted by the laser emission portion.

The first light transmitting member may be formed of a rigid material, and the second light transmitting member may be formed of an elastic material.

According to the display panel manufacturing device according to the embodiments, a laser beam emitted toward or incident a surrounding area other than the micro LED is reflected by a reflective member of the light transmitting plate, such that the laser beam is applied precisely to the micro-LED, and the uniformity of the pressing force applied to the micro-LED is increased. Accordingly, manufacturing defects of the target substrate or display panel may be prevented and manufacturing efficiency may be improved.

However, the effects of the present disclosure are not limited to the aforementioned effects, and various other effects are included in the present specification.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of the present disclosure will become more apparent by describing in detail example embodiments thereof with reference to the attached drawings, in which:
FIG. 1 is a plan view of a display device according to an embodiment.
FIG. 2 is a plan view schematically illustrating the emission area of each pixel according to an embodiment.
FIG. 3 is a plan view schematically illustrating the emission area of each pixel according to another embodiment.
FIG. 4 is a cross-sectional view schematically illustrating the line A - A' of FIG. 2 according to an embodiment.
FIG. 5 is an enlarged view schematically illustrating the first emission area of FIG. 4.
FIG. 6 is a cross-sectional view illustrating the light emitting element of FIG. 5 in detail.
FIG. 7 is a side cross-sectional view schematically illustrating a manufacturing device for a display panel according to an embodiment.
FIG. 8 is a front view schematically illustrating a top surface of the device for manufacturing the display panel illustrated in FIG. 7.
FIG. 9 is a front view illustrating the arrangement shape of the first reflective member and the light absorbing member illustrated in FIGS. 7 and 8.
FIG. 10 is a cross-sectional view of one side illustrating a micro LED transfer method using a manufacturing device In an embodiment.
FIG. 11 is a cross-sectional view of one side schematically illustrating a display panel manufacturing device according to another embodiment.
FIG. 12 is a front view illustrating the arrangement shape of the first reflective member, the second reflective member, and the light absorbing member illustrated in FIG. 11.
FIG. 13 is a cross-sectional view of one side illustrating a micro LED transfer method using the manufacturing device of FIG. 12.
FIG. 14 is a side cross-sectional view schematically illustrating a display panel manufacturing device according to another embodiment.
FIGS. 15 to 17 are cross-sectional views of one side illustrating a micro LED transfer method using the manufacturing device of FIG. 14.
FIG. 18 is a side cross-sectional view schematically illustrating a display panel manufacturing device according to another embodiment.
FIGS. 19 and 20 are cross-sectional views of one side illustrating a micro LED transfer method using the manufacturing device of FIG. 18.
FIG. 21 is a side cross-sectional view schematically illustrating a display panel manufacturing device according to another embodiment.
FIGS. 22 and 23 are cross-sectional views of one side illustrating a micro LED transfer method using the manufacturing device of FIG. 21.
FIG. 24 is a side cross-sectional view schematically illustrating a display panel manufacturing device according to another embodiment.
FIGS. 25 and 26 are cross-sectional views of one side illustrating a micro LED transfer method using the manufacturing device of FIG. 24.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. In some aspects, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. In an example in which "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, example embodiments of the present disclosure will be described in detail with reference to the accompanying drawings.

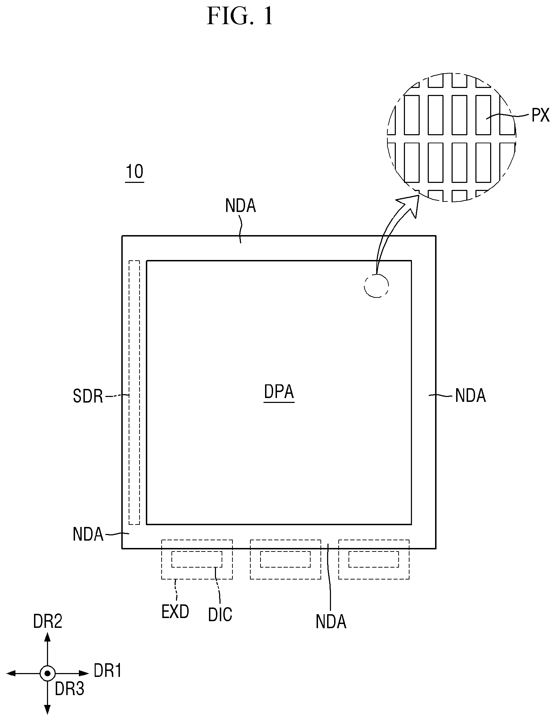

FIG. 1 is a plan view of a display device according to an embodiment.

Referring to FIG. 1, a display device 10 according to an embodiment may be applied to a smartphone, cell phone, tablet PC, personal digital assistant (PDA), portable multimedia player (PMP), television, gaming device, wristwatch-type electronic device, head-mounted display, monitor of a personal computer, laptop computer, car navigation, car instrument panel, digital camera, camcorder, exterior billboard, billboard, medical device, testing device, various consumer electronics such as, for example, refrigerators and washing machines, or Internet of Things device. In this specification, a television is described as an example of a display device, and the TV may have high or ultra-high resolution such as, for example, HD, UHD, 4K, 8K, and the like.

In some aspects, the display device 10 according to an embodiment may be classified into various ways depending on the display method. For example, the classification of display device may include an organic light-emitting display device (OLED), an inorganic light-emitting display device (inorganic EL), a quantum dot light-emitting display device (QED), a micro-LED display device (micro-LED), a nano-LED display device (nano-LED), a plasma display device (PDP), a field emission display device (FED), a cathode ray display device (CRT), a liquid crystal display device (LCD), an electrophoretic display device (EPD), and the like. In the following, a micro LED display device will be described as an example as a display device, and the micro-LED display device applied in the embodiments will be abbreviated as simply the display device unless otherwise indicated. However, the embodiment is not limited to the micro LED display device, and other display devices listed above or known in the art may be applied to the extent that they share the technical ideas as set out in the appended claims.

Furthermore, in the following drawings, the first direction DR1 refers to the horizontal direction of the display device 10, the second direction DR2 refers to the vertical direction of the display device 10, and the third direction DR3 refers to the thickness direction of the display device 10. In this case, "left", "right", "up", and "down" refers to directions when the display device 10 is viewed from a plane. For example, "right" refers to one side of the first direction DR1, "left" refers to the other side of the first directionDR1, "top" refers to one side of the second direction DR2, and "bottom" refers to the other side of the second direction DR2. Furthermore, "top" or "front" refers to one side of the third direction DR3, and "bottom" or "back" refers to the other side of the third direction DR3.

The display device 10 according to an embodiment may have a circular, oval, or square shape in plan view, for example, a square shape. Furthermore, when the display device 10 is a television, the display device 10 may have a rectangular shape with the long side located in the horizontal direction. However, the display device 10 is not limited thereto, and the long side may be positioned in the vertical direction and may be installed to be rotatable such that the long side may be variably positioned in the horizontal or vertical direction.

The display device 10 may include a display area DPA and a non-display area NDA. The display area DPA may be an active area where an image is displayed. The display area DPA may have a square shape in a plan view similar to the overall shape of the display device 10 but is not limited to this and may have a circular or oval shape.

The display area DPA may include a plurality of pixels PX. The plurality of pixels PX may be arranged in a matrix direction. The shape of each pixel PX may be rectangular or square in plan view but is not limited thereto and may be a rhombic shape with each side inclined with respect to the direction of one side of the display device 10. The plurality of pixels PX may include multiple color pixels PX. For example, the plurality of pixels PX may include, but are not limited to, a red first color pixel PX, a green second color pixel PX, and a blue third color pixel PX. Each color pixel PX may be alternately arranged in a stripe type or a pentile type.

A non-display area NDA may be arranged around the display area DPA. The non-display area NDA may completely or partially surround the display area DPA. The display area DPA may have various shapes, such as, for example, circular or square. The non-display area NDA may be formed to surround the display area DPA. The non-display area NDA may be composed of a bezel of the display device 10.

A driving circuit or driving element that drives the display area DPA may be disposed in the non-display area NDA. In an embodiment, a pad portion is provided on the display substrate of the display device 10 in the non-display area NDA disposed adjacent to the first side (lower side in FIG. 1) of the display device 10, and an external device EXD may be mounted on the electrode of the pad portion. Examples of the external device EXD include a connection film, a printed circuit board, a driving chip DIC, a connector, a wiring connection film, and the like. A scan driving portion SDR formed directly on the display substrate of the display device 10 may be disposed in the non-display area NDA adjacent to the second side (left side in FIG. 1) of the display device 10.

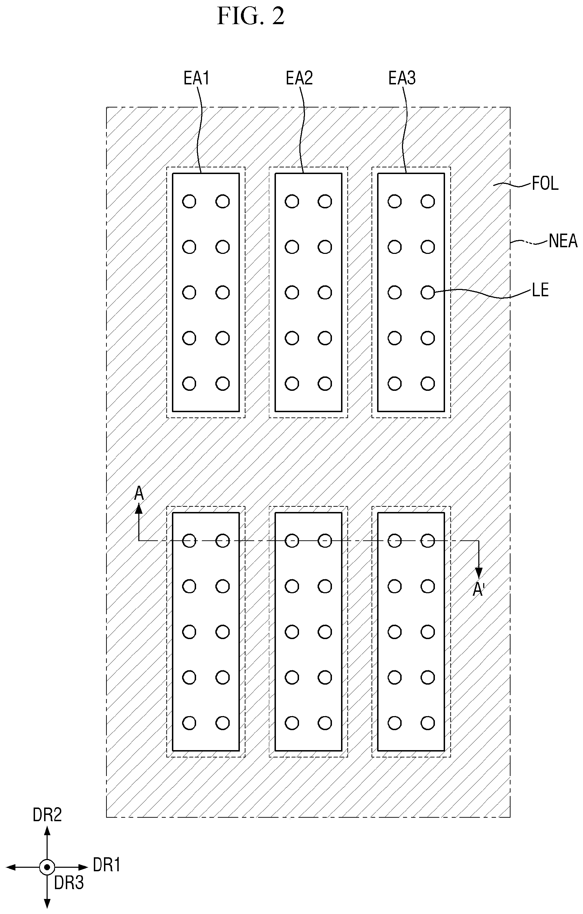

FIG. 2 is a plan view schematically illustrating the emission area of each pixel according to an embodiment.

Referring to FIG. 2, a plurality of pixels PX may be arranged in a matrix direction, and the plurality of pixels PX may be divided into a red first color pixel PX, a green second color pixel PX, and a blue third color pixel PX. In some aspects, a white fourth color pixel PX may be further included.

The pixel electrode of the first color pixel PX is located in the first emission area EA1, but at least part of the pixel electrode may extend to the non-emission area NEA. The pixel electrode of the second color pixel PX is located in the second emission area EA2, but at least portion of the pixel electrode may extend to the non-emission area NEA. The pixel electrode of the third color pixel PX is located in the third emission area EA3, but at least portion of the pixel electrode may extend to the non-emission area NEA. The pixel electrode of each pixel PX may be connected to one or more switching elements included in the respective pixel circuit penetrating at least one layer of insulating layer.

A plurality of light emitting elements LE are disposed on the pixel electrode of the first emission area EA1, the pixel electrode of the second emission area EA2, and the pixel electrode of the third emission area EA3. Here, each light emitting element LE may be formed of a micro LED. The light emitting elements LE are disposed in each of the first emission area EA1, the second emission area EA2, and the third emission area EA3. In some aspects, a red first color filter, a green second color filter, and a blue third color filter may be disposed on the first emission area EA1, the second emission area EA2, and the third emission area EA3, respectively, where the plurality of light emitting elements LE are disposed. A first organic layer FOL may be disposed in the non-emission area NEA.

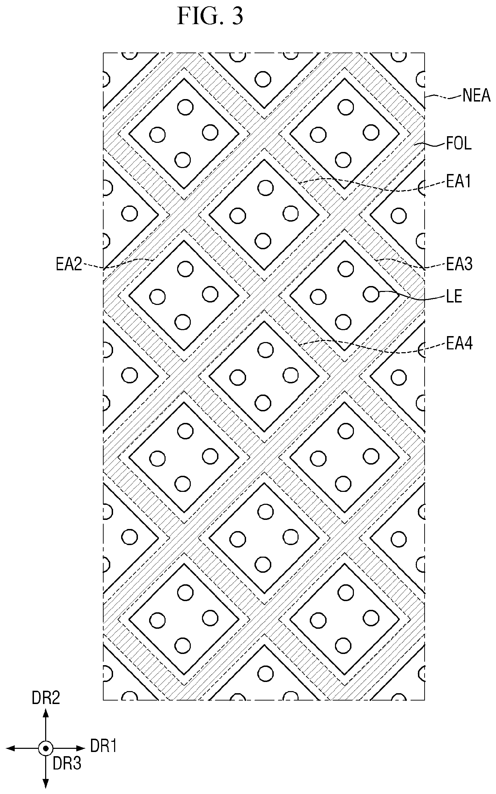

FIG. 3 is a plan view schematically illustrating the emission area of each pixel according to another embodiment.

Referring to FIG. 3, the shape of each pixel PX is not limited to a rectangular or square shape in plan view but may be a rhombus shape in which each side is inclined with respect to one side of the display device 10 to form a pentile structure. Accordingly, each pixel PX of the pen tile structure may be formed in a rhombus shape with a first emission area EA1 of the first color pixel PX, a second emission area EA2 of the second color pixel PX, a third emission area EA3 of the third color pixel PX, and a fourth emission area EA4 of any of the first to third colors of the color pixel PX.

The size or planar area of the first to fourth emission areas EA1 to EA4 of each pixel PX may be the same or different from each other. Similarly, the number of light emitting elements LE formed in the first to fourth emission areas EA1 to EA4 may be the same or different from each other.

The area of the first emission area EA1, the area of the second emission area EA2, the area of the third emission area EA3, and the area of the fourth emission area EA4 may be substantially the same but may be different from each other, without limitation. The distance between adjacent first and second emission areas EA1 and EA2 that are adjacent to each other, the distance between the second and third emission areas EA2 and EA3 that are adjacent to each other, the distance between the adjacent first and third emission areas EA1 and EA3 that are adjacent to each other, and the distance between the adjacent third and fourth emission areas EA3 and EA4 that are adjacent to each other may be substantially the same or may be different from each other. The embodiments of this disclosure are not limited thereto.

In some aspects, the first emission area EA1 may emit the first light, the second emission area EA2 may emit the second light, and the third emission area EA3 and the fourth emission area EA4 may emit the third light but embodiments of the present disclosure are not limited thereto. For example, the first emission area EA1 may emit the second light, the second emission area EA2 may emit the first light, and the third and fourth emission areas EA3 and EA4 may emit the third light. Alternatively, the first emission area EA1 may emit the third light, the second emission area EA2 may emit the second light, and the first and fourth emission areas EA3 and EA4 may emit the first light. Alternatively, at least one of the first to fourth emission areas EA1 to EA4 may emit a fourth light. The fourth light may be light in a yellow wavelength band. That is, the main peak wavelength of the fourth light may be located at approximately 550 nm to 600 nm, but the embodiments of the present disclosure are not limited thereto.

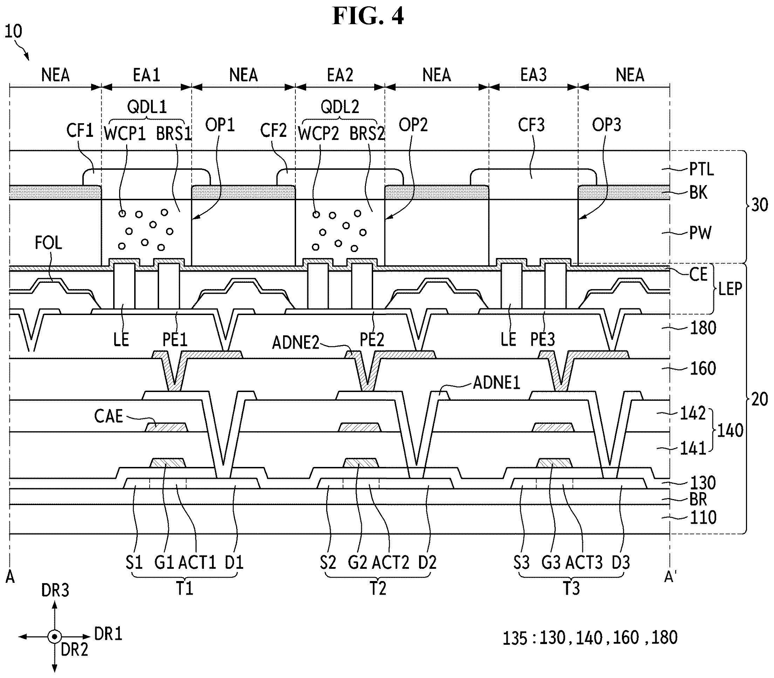

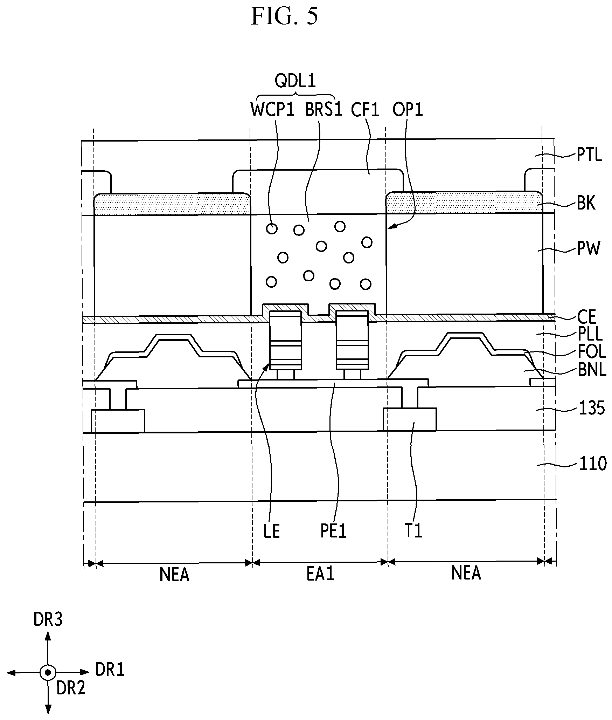

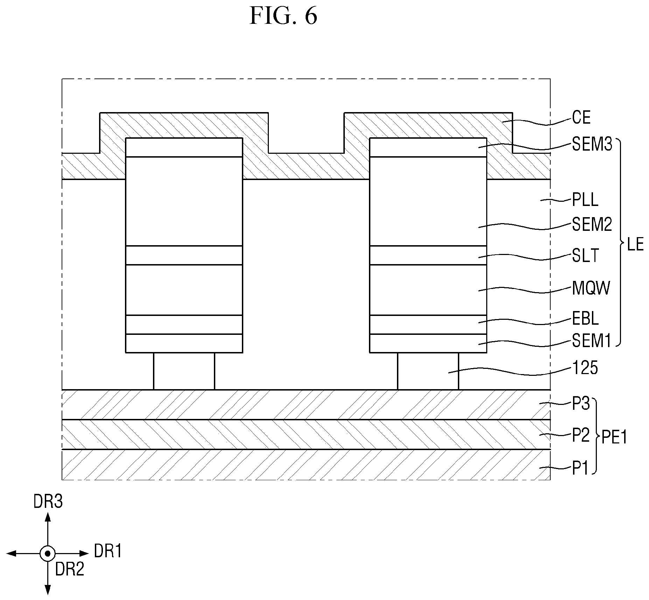

FIG. 4 is a cross-sectional view schematically illustrating the line A - A' of FIG. 2 according to an embodiment. FIG. 5 is an enlarged view schematically illustrating the first emission area of FIG. 4. FIG. 6 is a cross-sectional view illustrating the light emitting element of FIG. 5 in detail. In FIG. 5, the barrier film BR is omitted. Also, in FIG. 5, the gate insulating layer 130, the insulating film 140, the first planarization film 160, and the second planarization film 180 of FIG. 4 are combined to form an insulating layer 135.

Referring to FIGS. 4 to 6, the display panel of the display device 10 may include a display substrate 20 and a wavelength conversion portion 30 disposed on the display substrate 20.

A barrier film BR may be disposed on the first substrate 110 of the display substrate 20. The first substrate 110 may be formed of an insulating material such as, for example, polymer resin. For example, the first substrate 110 may be formed of polyimide. The first substrate 110 may be a flexible substrate capable of bending, folding, rolling, and the like.

The barrier film BR is a film to protect the thin film transistors T1, T2, and T3 and the light emitting element LE from moisture penetrating through the first substrate 110, which is vulnerable to moisture penetration. The barrier film BR may be composed of a plurality of inorganic films stacked alternately. For example, the barrier film BR may be formed as a multilayer of alternately stacked inorganic films of one or more of a silicon nitride layer, a silicon oxynitride layer, a silicon oxide layer, a titanium oxide layer, and an aluminum oxide layer.

Each transistor T1, T2, and T3 may be disposed on the barrier film BR. Each thin film transistor T1, T2, and T3 includes an active layer ACT1, a gate electrode G1, a source electrode S1, and a drain electrode D1.

The active layer ACT1, source electrode S1, and drain electrode D1 of the thin film transistors T1, T2, and T3 may be disposed on the barrier film BR. The active layer ACT1 of the thin film transistors T1, T2, and T3 may include polycrystalline silicon, monocrystalline silicon, low temperature polycrystalline silicon, amorphous silicon, or an oxide semiconductor. The active layer ACT1 overlapping the gate electrode G1 in the third direction (Z-axis direction), which is the thickness direction of the first substrate 110, may be defined as a channel region. The source electrode S1 and the drain electrode D1 are regions that do not overlap with the gate electrode G1 in the third direction (z-axis direction) and may have conductivity due to doping of ions or impurities in the silicon semiconductor or oxide semiconductor.

A gate insulating layer 130 may be disposed on the active layer ACT1, the source electrode S1, and the drain electrode D1 of the thin film transistors T1, T2, and T3. The gate insulating layer 130 may be formed of an inorganic film, such as, for example, a silicon nitride layer, a silicon oxynitride layer, a silicon oxide layer, a titanium oxide layer, or an aluminum oxide layer.

A gate electrodes G1 of thin film transistors T1, T2, and T3 may be disposed on the gate insulating layer 130. The gate electrode G1 may overlap the active layer ACT1 in the third direction (Z-axis direction). The gate electrode G1 may be formed of an inorganic film, such as, for example, a silicon nitride layer, a silicon oxynitride layer, a silicon oxide layer, a titanium oxide layer, or an aluminum oxide layer.

A first interlayer insulating film 141 may be disposed on the gate electrode G1 of the thin film transistors T1, T2, and T3. The first interlayer insulating film 141 may be formed of an inorganic film, such as, for example, a silicon nitride layer, a silicon oxynitride layer, a silicon oxide layer, a titanium oxide layer, or an aluminum oxide layer. The first interlayer insulating film 141 may be formed of a plurality of inorganic films.

A capacitor electrode CAE may be disposed on the first interlayer insulating film 141. The capacitor electrode CAE may overlap the gate electrode G1 of the thin film transistors T1, T2, and T3 in the third direction (Z-axis direction). Since the first interlayer insulating film 141 has a predetermined dielectric constant, a capacitor may be formed by the capacitor electrode CAE, the gate electrode G1, and the first interlayer insulating film 141 disposed between them. The capacitor electrode CAE may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second interlayer insulating film 142 may be disposed on the capacitor electrode CAE. The second interlayer insulating film 142 may be formed of an inorganic film, such as, for example, a silicon nitride layer, a silicon oxynitride layer, a silicon oxide layer, a titanium oxide layer, or an aluminum oxide layer. The second interlayer insulating film 142 may be formed of a plurality of inorganic films.

A first anode connection electrode ANDE1 may be disposed on the second interlayer insulating film 142. The first anode connection electrode ANDE1 may be connected to the drain electrode D1 of the thin film transistor ST1 through a first connection contact hole ANCT1 penetrating the gate insulating layer 130, the first interlayer insulating film 141, and the second interlayer insulating film 142. The first anode connection electrode ANDE1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first planarization film 160 may be disposed on the first anode connection electrode ANDE1 to flatten the steps caused by the thin film transistors T1, T2, and T3. The first planarization film 160 may be formed of an organic film such as, for example, an acrylic resin, an epoxy resin, a phenolic resin, a polyamide resin, a polyimide resin, or the like.

A second anode connection electrode ANDE2 may be disposed on the first planarization film 160. The second anode connection electrode ANDE2 may be connected to the first anode connection electrode ANDE1 through a second connection contact hole ANCT2 penetrating the first planarization film 160. The second anode connection electrode ANDE2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A second planarization film 180 may be disposed on the second anode connection electrode ANDE2. The second planarization film 180 may be formed of an organic film such as, for example, an acrylic resin, an epoxy resin, a phenolic resin, a polyamide resin, a polyimide resin, or the like.

A light emitting element portion LEP may be formed on the second planarization film 180. The light emitting element portion LEP may include a plurality of pixel electrodes PE1, PE2, and PE3, a plurality of light emitting elements LE, and a common electrode CE.

The plurality of pixel electrodes PE1, PE2, and PE3 may include a first pixel electrode PE1, a second pixel electrode PE2, and a third pixel electrode PE3. The first pixel electrode PE1, the second pixel electrode PE2, and the third pixel electrode PE3 may serve as the first electrode of the light emitting element LE and may be an anode electrode or a cathode electrode. The first pixel electrode PE1 may be located in the first emission area EA1 but may extend at least partially into the non-emission area NEA. The second pixel electrode PE2 may be located in the second emission area EA2 but may extend at least partially into the non-emission area NEA. The third pixel electrode PE3 is located in the third emission area EA3 but may extend at least partially into the non-emission area NEA. The first pixel electrode PE1 may be connected to a first switching element T1 by penetrating the gate insulating layer 130, the second pixel electrode PE2 may be connected to a second switching element T2 by penetrating the gate insulating layer 130, and the third pixel electrode PE3 may be connected to the third switching element T3 by penetrating the gate insulating layer 130.

The first pixel electrode PE1, the second pixel electrode PE2, and the third pixel electrode PE3 may be reflective electrodes. The first pixel electrode PE1, the second pixel electrode PE2, and the third pixel electrode PE3 may be formed of titanium (Ti) or copper (Cu) or an alloy material of titanium (Ti) and copper (Cu). In some aspects, each of the first pixel electrode PE1, the second pixel electrode PE2, and the third pixel electrode PE3 may have a laminated film structure of Ti (Titanium) and Copper (Cu). Further, the first pixel electrode PE1, the second pixel electrode PE2, and the third pixel electrode PE3 may be formed from a material layer having a high work function of titanium oxide (TiO₂), indium tin oxide (ITO), indium zinc oxide (IZO), zinc oxide (ZnO), indium tin zinc oxide (ITZO), or magnesium oxide (MgO) and silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), titanium (Ti), copper (Cu), or mixtures thereof, or the like. A material layer with a high work function may be disposed above the reflective material layer and may be disposed close to the light emitting element LE. The first pixel electrode PE1, the second pixel electrode PE2, and the third pixel electrode PE3 may have a multilayer structure of ITO/Mg, ITO/MgF, ITO/Ag, ITO/Ag/ITO, but are not limited thereto.

A bank BNL may be located on the first pixel electrode PE1, the second pixel electrode PE2, and the third pixel electrode PE3. The bank BNL may include an opening exposing the first pixel electrode PE1, an opening exposing the second pixel electrode PE2, and an opening exposing the third pixel electrode PE3, and may define an emission area EA1, a second emission EA2, a third emission EA3, and a non-emission area NEA. In other words, the area of the first pixel electrode PE1 that is not covered by the bank BNL and is exposed may be the first emission area EA1. The area of the second pixel electrode PE2 that is not covered by the bank BNL and is exposed may be the second emission area EA2. The area of the third pixel electrode PE3 that is not covered by the bank BNL and is exposed may be the third emission area EA3. In some aspects, the area where the bank BNL is located may be the non-emission area NEA.

The bank BNL may include an organic insulating material, for example, a polyacrylates resin, an epoxy resin, a phenolic resin, a polyamides resin, a polyimides rein, unsaturated polyesters resin, poly phenylenethers resin, polyphenylenesulfides resin, or benzocyclobutene (BCB).

In an embodiment, the bank BNL may overlap with the color filters CF1, CF2, and CF3 and the light blocking member BK of the wavelength converter (or wavelength conversion portion) 30, which will be described later. In an embodiment, the bank BNL may completely overlap light blocking member BK. In some aspects, the bank BNL may overlap the first color filter CF1, the second color filter CF2, and the third color filter CF3.

A plurality of light emitting elements LE may be disposed on the first pixel electrode PE1, the second pixel electrode PE2, and the third pixel electrode PE3.

As illustrated in FIGS. 5 and 6, the light emitting element LE may be disposed in each of the first emission area EA1, the second emission area EA2, and the third emission area EA3. The light emitting element LE may be a vertical light emitting diode element extending long in the third direction DR3. That is, the length of the light emitting element LE in the third direction DR3 may be longer than the length in the horizontal direction. The length in the horizontal direction refers to the length in the first direction DR1 or the length in the second direction DR2. For example, the length of the light emitting element LE in the third direction DR3 may be approximately 1 to 5 µm.

Each light emitting element LE may be a micro light emitting diode (micro LED). The light emitting element LE may be connected to a connection electrode 125, a first semiconductor layer SEM1, an electron blocking layer EBL, an active layer MQW, a superlattice layer SLT, a second semiconductor layer SEM2, and a third semiconductor layer SEM3 in the thickness direction of the display substrate 20, i.e., the third direction DR3. The connection electrode 125, the first semiconductor layer SEM1, the electron blocking layer EBL, the active layer MQW, the superlattice layer SLT, the second semiconductor layer SEM2, and the third semiconductor layer SEM3 may be stacked sequentially in the third direction DR3.

The light emitting element LE may have a cylindrical shape, a disk shape, a bridge shape, or a rod shape where the width is longer than the height. However, embodiments of the present disclosure are not limited thereto, and the light emitting element LE may have a shape such as, for example, a rod, wire, tube, or the like, a polygonal shape such as, for example, a cube, rectangular cube, hexagonal column, or the like, or a shape that extends in one direction but has a partially sloped outer surface.

The connection electrode 125 may be disposed on top of each of the plurality of pixel electrodes PE1, PE2, and PE3. In the following, the light emitting element LE disposed on the first pixel electrode PE1 will be described as an example.

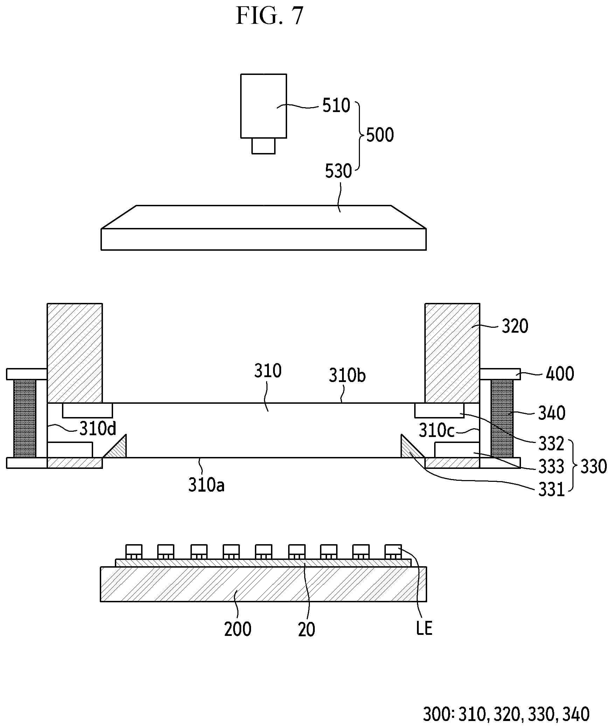

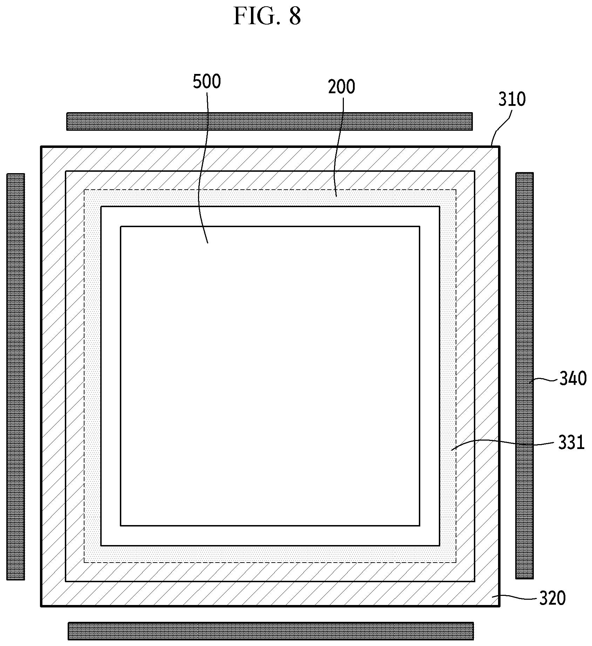

The connection electrode 125 may bond with the first pixel electrode PE1 and serve to apply an emission signal to the light emitting element LE. The connection electrode 125 may be an ohmic connection electrode. However, the electrode is not limited to this and may be a Schottky connection electrode. The light emitting element LE may include at least one connection electrode 125. FIG. 7 and 8 illustrate that the light emitting element LE includes one connection electrode 125, but embodiments of the present disclosure are not limited thereto. In some cases, the light emitting element LE may include a greater number of connection electrodes 125 or may be omitted. The description of the light emitting element LE described later may be applied equally even if the number of connection electrodes 125 is different or a different structure is added.

The connection electrode 125 may reduce resistance and improve adhesion between the light emitting element LE and the first pixel electrode PE1 when the light emitting element LE is electrically connected to the first pixel electrode PE1 in the display device 10 according to an embodiment. The connection electrode 125 may include a conductive metal oxide. For example, the connection electrode 125 may be ITO. Since the connection electrode 125 is connected by direct contact with the lower first pixel electrode PE1, the connection electrode 125 may be formed of the same material as the first pixel electrode PE1. Further, the connection electrode 125 may optionally further include a reflective electrode formed of a highly reflective metal material such as, for example, aluminum (Al) or an anti-diffusion layer including nickel (Ni). Accordingly, the adhesion between the connection electrode 125 and the first pixel electrode PE1 may be improved, thereby increasing the contact characteristics.

Referring to FIG. 6, In an embodiment, the first pixel electrode PE1 may include a lower electrode layer P1, a reflective layer P2, and an upper electrode layer P3. The lower electrode layer P1 may be disposed at the bottom of the first pixel electrode PE1 and may be electrically connected to the switching element. The lower electrode layer P1 may include a metal oxide, for example, titanium oxide (TiO₂), indium tin oxide (ITO), indium zinc oxide (IZO), zinc oxide (ZnO), indium tin zinc oxide (ITZO), or magnesium oxide (MgO).

The reflective layer P2 may be disposed on the lower electrode layer P1 to reflect light emitted from the light emitting element LE to the upper electrode layer. The reflective layer P2 may include a highly reflective metal, for example, silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), or a mixture thereof.

The upper electrode layer P3 is disposed on the reflective layer P2 and may be in direct contact with the light emitting element LE. The upper electrode layer P3 may be disposed between the reflective layer P2 and the connection electrode 125 of the light emitting element LE and may be in direct contact with the connection electrode 125. As described herein, the connection electrode 125 is formed of metal oxide, and the upper electrode layer P3 may also be formed of metal oxide in the same way as the connection electrode 125.

The upper electrode layer P3 may be formed of titanium (Ti) or copper (Cu) or an alloy material of titanium (Ti) and copper (Cu). In some aspects, the upper electrode layer P3 may have a laminated film structure of Ti (Titanium) and Copper (Cu). Further, the upper electrode layer P3 may include titanium oxide (TiO₂), indium tin oxide (ITO), indium zinc oxide (IZO), zinc oxide (ZnO), indium tin zinc oxide (ITZO), or magnesium oxide (MgO). In an embodiment, when the connection electrode 125 is formed of ITO, the first pixel electrode PE1 may be formed of a multilayer structure of ITO/Ag/ITO.

The first semiconductor layer SEM1 may be disposed on the connection electrode 125. The first semiconductor layer SEM1 may be a p-type semiconductor and may include a semiconductor material having a chemical formula of AlxGayIn1-x-yN(0≤x≤1,0≤y≤1, 0≤x+y≤1). For example, the first semiconductor layer SEM1 may be any one or more of p-type doped AlGaInN, GaN, AlGaN, InGaN, AIN, and InN. The first semiconductor layer SEM1 may be doped with a p-type dopant, and the p-type dopant may be Mg, Zn, Ca, Se, Ba, or the like. For example, the first semiconductor layer SEM1 may be p-GaN doped with p-type Mg. The thickness of the first semiconductor layer SEM1 may range from 30 nm to 200 nm but is not limited thereto.

The electron blocking layer EBL may be disposed on the first semiconductor layer SEM1. The electron blocking layer EBL may be a layer to suppress or prevent too many electrons from flowing into the active layer MQW. For example, the electron blocking layer EBL may be p-AlGaN doped with p-type Mg. The thickness of the electron blocking layer EBL may range from 10 nm to 50 nm but is not limited thereto. In some aspects, the electron blocking layer EBL may be omitted.

The active layer MQW may be disposed on the electron blocking layer EBL. The active layer MQW may emit light by combining electron-hole pairs according to an electrical signal applied through the first semiconductor layer SEM1 and the second semiconductor layer SEM2.

The active layer MQW may include a single or multiple quantum well structure. If the active layer includes a material with a multi-quantum well structure, the active layer may be a stacked structure with a plurality of well layers and a barrier layer alternating with each other. In this case, the well layer may be formed of InGaN and the barrier layer may be formed of GaN or AlGaN, but is not limited thereto. The thickness of the well layer may be approximately 1 to 4 nm, and the thickness of the barrier layer may be 3 nm to 10 nm.

Alternatively, the active layer MQW may have a structure in which a semiconductor material having a large band gap energy and a semiconductor material having a small band gap energy are alternately stacked with each other and may include other Group 3 to Group 5 semiconductor materials depending on the wavelength band of the emitted light. The light emitted from the active layer MQW is not limited to the first light and may emit second light (light of a green wavelength band) or third light (light of a red wavelength band) according to circumstances.

Specifically, the color of light emitted from the active layer MQW may vary depending on the indium (In) content. For example, as the content of indium (In) decreases, the wavelength band of light emitted by the active layer may shift to a red wavelength band, and as the content of indium (In) increases, the wavelength band of light emitted may shift to a blue wavelength band. In one example, if the indium (In) content is within 15%, the active layer MQW may emit first light in a red wavelength band with a main peak wavelength ranging from approximately 600 nm to 750 nm. In contrast, in one example, if the indium (In) content is set to 25%, the active layer MQW may emit second light in a green wavelength band with a main peak wavelength ranging from approximately 480 nm to 560 nm. Furthermore, when the indium (In) content is 35% or more, the active layer MQW may emit third light in a blue wavelength band with a main peak wavelength ranging from approximately 370 nm to 460 nm. Through FIG. 6, an example in which the active layer MQW emits light in a blue wavelength band with a main peak wavelength ranging from approximately 370 nm to 460 nm will be described.

The superlattice layer SLT may be disposed on the active layer MQW. The superlattice layer SLT may be a layer for relieving stress between the second semiconductor layer SEM2 and the active layer MQW. For example, the superlattice layer SLT may be formed of InGaN or GaN. The thickness of the superlattice layer SLT may be approximately 50 to 200 nm. The superlattice layer SLT may be omitted.

The second semiconductor layer SEM2 may be disposed on the superlattice layer SLT. The second semiconductor layer SEM2 may be an n-type semiconductor. The second semiconductor layer SEM2 may include a semiconductor material having the chemical formula AlxGayIn1-x-yN(0≤x≤1,0≤y≤1, 0≤x+y≤1). For example, the second semiconductor layer SEM2 may be one or more of n-type doped AlGaInN, GaN, AlGaN, InGaN, AIN, and InN. The second semiconductor layer SEM2 may be doped with an n-type dopant, and the n-type dopant may be Si, Ge, Sn, or the like. For example, the second semiconductor layer SEM2 may be n-GaN doped with n-type Si. The thickness of the second semiconductor layer SEM2 may range from 2 µm to 4 µm but is not limited thereto.

The third semiconductor layer SEM3 may be disposed on the second semiconductor layer SEM2. The third semiconductor layer SEM3 may be disposed between the second semiconductor layer SEM2 and the common electrode CE. The third semiconductor layer SEM3 may be an undoped semiconductor. The third semiconductor layer SEM3 may include the same material as the second semiconductor SEM2 but may be a material undoped with an n-type or p-type dopant. In an embodiment, the third semiconductor layer SEM3 may be at least one of undoped InAlGaN, GaN, AlGaN, InGaN, AIN, and InN but is not limited thereto.

A planarization layer PLL may be disposed on the bank BNL and the plurality of pixel electrodes PE1, PE2, and PE3. The planarization layer PLL may flatten a lower step such that a common electrode CE, which will be described later, may be formed. The planarization layer PLL may be formed at a predetermined height such that at least a portion of the plurality of light emitting elements LE, for example, an upper portion, may protrude above the planarization layer PLL. In other words, the height of the planarization layer PLL relative to the top surface of the first pixel electrode PE1 may be less than the height of the light emitting element LE.

The planarization layer PLL may include an organic material to flatten the lower step. For example, the planarization layer PLL may include a polyacrylates resin, an epoxy resin, a phenolic resin, a polyamides resin, a polyimides rein, an unsaturated polyesters resin, a polyphenylene resin, or a polyester resin, unsaturated polyesters resin, poly phenylenethers resin, polyphenylenesulfides resin, or benzocyclobutene (BCB).

A common electrode CE may be disposed on the planarization layer PLL and the plurality of light emitting elements LE. Specifically, the common electrode CE may be disposed on one surface of the first substrate 110 on which the light emitting element LE is formed and may be disposed throughout the display area DPA and the non-display area NDA. The common electrode CE is disposed to overlap each of the emission areas EA1, EA2, and EA3 in the display area DPA, and may be thin such that light may be emitted.

The common electrode CE may be directly disposed on the top and side surfaces of the plurality of light emitting elements LE. The common electrode CE may directly contact the second semiconductor layer SEM2 and the third semiconductor layer SEM3 on the side of the light emitting element LE. As illustrated in FIG. 6, the common electrode CE covers the plurality of light emitting elements LE and may be a common layer arranged to commonly connect the plurality of light emitting elements LE. Since the conductive second semiconductor layer SEM2 has a structure in which each light emitting element LE is patterned, the common electrode CE may directly contact a side of the second semiconductor layer SEM2 of each light emitting element LE such that a common voltage may be applied to each light emitting element LE.

Since the common electrode CE is disposed entirely on the first substrate 110 and applies a common voltage, the common electrode CE may include a material with low resistance. Further, the common electrode CE may be formed to be thin to facilitate light transmission. For example, the common electrode CE may include a material having a low resistance, such as, for example, aluminum (Al), silver (Ag), copper (Cu), or the like. In some aspects, the common electrode CE may be formed of a transparent conductive oxide, such as, for example, indium tin oxide (ITO) and indium zinc oxide (IZO).

The thickness of the common electrode CE may be approximately 10Å to 200Å but is not limited thereto.

The above-described light emitting elements LE may receive a pixel voltage or anode voltage from the pixel electrode through the connection electrode 125 and may receive a common voltage through the common electrode CE. The light emitting element LE may emit light with a predetermined brightness depending on the voltage difference between the pixel voltage and the common voltage.

In this embodiment, by disposing a plurality of light emitting elements LE, that is, inorganic light emitting diodes, on the pixel electrodes PE1, PE2, and PE3, the disadvantages of organic light emitting diodes, which are vulnerable to external moisture or oxygen, may be eliminated and the lifespan and reliability may be improved.

In some embodiments, a first organic layer FOL may be disposed on the bank BNL disposed in the non-emission area NEA.

The first organic layer FOL overlaps the non-emission area NEA and may be disposed to non-overlap with the emission areas EA1, EA2, and EA3. The first organic layer FOL is directly disposed on the bank BNL and may be disposed to be spaced apart from a plurality of adjacent pixel electrodes PE1, PE2, and PE3. The first organic layer FOL may be disposed entirely on the first substrate 110, surrounding the plurality of emission areas EA1, EA2, and EA3. The first organic layer FOL may be disposed overall in a lattice shape.

The first organic layer FOL may serve to detach the plurality of light emitting elements LE that are in contact with the first organic layer FOL, which is the non-emission area NEA, as will be explained in the manufacturing process described later. In an example in which the first organic layer FOL is irradiated with laser light, the first organic layer FOL absorbs energy and the temperature of the first organic layer FOL instantly increases, resulting in ablation. Accordingly, the plurality of light emitting elements LE in contact with the top surface of the first organic layer FOL may be detached from the top surface of the first organic layer FOL.

The first organic layer FOL may include a polyimide-based compound. The polyimide-based compound of the first organic layer FOL may include a cyano group to absorb light with a wavelength of 308 nm, for example, laser light. In an embodiment, the first organic layer FOL and the bank BNL each include a polyimide-based compound but may include different polyimide-based compounds. For example, the bank BNL may be formed of a polyimide-based compound that does not contain a cyano group, and the first organic layer FOL may be formed of a polyimide-based compound that includes a cyano group. For laser light with a wavelength of 308 nm, the transmittance of the first organic layer FOL may be less than the transmittance of the bank BNL, such that the transmittance of the bank BNL may be about 60% or more and the transmittance of the first organic layer FOL may be 0%. Further, the absorption rate of the first organic layer FOL for laser light with a wavelength of 308 nm may be 100%. The first organic layer FOL may have a thickness ranging from about 2Å to 10 µm. If the thickness of the first organic layer FOL is 2 Å or more, the absorption rate of laser light with a wavelength of 308 nm may be improved. If the thickness of the first organic layer FOL is 10 µm or less, a step between the first organic layer FOL and the pixel electrode PE1 may be prevented from increasing, thereby facilitating the bonding of the light emitting element LE on the pixel electrode in the process described later.

The wavelength conversion portion 30 may be disposed on the light emitting element portion LEP. The wavelength converter 30 may include a partition wall PW, a wavelength conversion layer QDL, color filters CF1, CF2, and CF3, a light blocking member BK, and a protective layer PTL.

The partition wall PW is disposed on the common electrode CE of the display area DPA and, together with the bank BNL, may compartmentalize a plurality of emission areas EA1, EA2, and EA2. The partition wall PW is arranged to extend in the first direction DR1 and the second direction DR2 and may be formed in a grid-like pattern throughout the display area DPA. Furthermore, the partition wall PW may not overlap with the plurality of emission areas EA1, EA2, and EA3 and may overlap with the non-emission area NEA.

The partition wall PW may include a plurality of openings OP1, OP2, and OP3 exposing the lower common electrode CE. The plurality of openings OP1, OP2, and OP3 may include a first opening OP1 overlapping the first emission area EA1, a second opening OP2 overlapping the second emission area EA2, and a third opening OP3 overlapping the third emission area EA3. Here, the plurality of openings OP1, OP2, and OP3 may correspond to the plurality of emission areas EA1, EA2, and EA3. That is, the first opening OP1 corresponds to the first emission area EA1, the second opening OP2 corresponds to the second emission area EA2, and the third opening OP3 corresponds to the third emission area EA3.

The partition wall PW may serve to provide a space for forming the first and second wavelength conversion layers QDL1 and QDL2. To this end, the partition wall PW may be formed of a predetermined thickness. For example, the thickness of the partition wall PW may be in the range of 1 *µ*m to 10 *µ*m. The partition wall PW may include an organic insulating material to have a predetermined thickness. The organic insulating material may include, for example, an epoxy-based resin, an acrylic-based resin, a cardo-based resin, or an imide-based resin.

The first wavelength conversion layer QDL1 may be disposed within each of the first openings OP1. The first wavelength conversion layer QDL1 may be formed in a dot-shaped island pattern spaced apart from each other. The first wavelength conversion layer QDL1 may include a first base resin BRS1 and a first wavelength conversion particles WCP1. The first base resin BRS1 may include a light-transmitting organic material. For example, the first base resin BRS1 may include an epoxy-based resin, an acrylic-based resin, a cardo-based resin, or an imide-based resin. The first wavelength conversion particle WCP1 may be a quantum dot (QD), a quantum rod, a fluorescent material, or a phosphorescent material. For example, quantum dots may be particulate materials that emit a specific color as electrons transition from the conduction band to the valence band.

The quantum dot may be a semiconductor nanocrystal material. The quantum dots have a specific bandgap depending on their composition and size and may absorb light and then emit light with a unique wavelength. Examples of the semiconductor nanocrystals of the quantum dots include group IV nanocrystals, group II-VI compound nanocrystals, group III-V compound nanocrystals, group IV-VI nanocrystals, or combinations thereof.

The first wavelength conversion layer QDL1 may be formed in the first opening OP1 of the first emission area EA1. The first wavelength conversion layer QDL1 may convert or shift the peak wavelength of incident light into light of another specific peak wavelength and emit it. The first wavelength conversion layer QDL1 may convert a portion of the blue light emitted from the light emitting element LE into light similar to red, which is the first light. The first wavelength conversion layer QDL1 emits light similar to red such that may be converted into red light, which is the first light, through the first color filter CF1.

The second wavelength conversion layer QDL2 may be disposed within each of the second openings OP2. The second wavelength conversion layer QDL2 may be formed in a dot-shaped island pattern spaced apart from each other. For example, the second wavelength conversion layer QDL2 may be disposed to overlap the second emission area EA2. The second wavelength conversion layer QDL2 may include a second base resin BRS2 and second wavelength conversion particles WCP2. The second base resin BRS2 may include a light-transmitting organic material. Accordingly, the second wavelength conversion layer QDL2 may convert or shift the peak wavelength of the incident light into light of another specific peak wavelength and emit it. The second wavelength conversion layer QDL2 may convert a portion of the blue light emitted from the light emitting element LE into light similar to green light, which is the second light. The second wavelength conversion layer QDL2 emits light similar to green and may be converted into red light, which is the first light, through the second color filter CF2.

In the third emission area EA3, a transparent, light-transmitting organic material is formed in the third opening OP3 (e.g., without other elements in the third opening OP3), such that the blue light emitted from the light emitting element LE may be emitted, as the blue light may pass through the third color filter CF3.

A plurality of color filters CF1, CF2, and CF3 may be disposed on the partition wall PW and the first and second wavelength conversion layers QDL1 and QDL2. The plurality of color filters CF1, CF2, and CF3 may be arranged to overlap the plurality of openings OP1, OP2, and OP3 and the first and second wavelength conversion layers QDL1 and QDL2. The plurality of color filters CF1, CF2, and CF3 may include a first color filter CF1, a second color filter CF2, and a third color filter CF3.

The first color filter CF1 may be disposed to overlap the first emission area EA1. Further, the first color filter CF1 may be disposed on the first opening OP1 of the partition wall PW, overlapping with the first opening OP1. The first color filter CF1 may transmit the first light emitted from the light emitting element LE and absorb or block the second light and the third light. For example, the first color filter CF1 may transmit light in a blue wavelength band and absorb or block light in other wavelength bands such as, for example, green and red.

The second color filter CF2 may be disposed to overlap the second emission area EA2. Further, the second color filter CF2 may be disposed on the second opening OP2 of the partition wall PW, overlapping with the second opening OP2. The second color filter CF2 may transmit the second light and absorb or block the first light and the third light. For example, the second color filter CF2 may transmit light in a green wavelength band and absorb or block light in other wavelength bands such as, for example, blue and red.

The third color filter CF3 may be arranged to overlap the third emission area EA3. Further, the third color filter CF3 may be disposed on the third opening OP3 of the partition wall PW, overlapping with the third opening OP3. The third color filter CF3 may transmit third light and absorb or block first light and second light. For example, the third color filter CF3 may transmit light in a red wavelength band and absorb or block light in other wavelength bands such as, for example, blue and green.

The planar area of each of the plurality of color filters CF1, CF2, and CF3 may be larger than the planar area of each of the plurality of emission areas EA1, EA2, and EA3. For example, the first color filter CF1 may be larger than the planar area of the first emission area EA1. The second color filter CF2 may be larger than the planar area of the second emission area EA2. The third color filter CF3 may be larger than the planar area of the third emission area EA3. However, the present disclosure is not limited to this, and the planar area of each of the plurality of color filters CF1, CF2, and CF3 may be equal to the planar area of each of the plurality of emission areas EA1, EA2, and EA3.

Referring to FIG. 5, a light blocking member BK may be disposed on the partition wall PW. The light blocking member BK may block the transmission of light by overlapping the non-emission area NEA. The light blocking member BK may be arranged in a substantially grid-like arrangement on a plane, similar to the bank BNL or partition wall PW. The light blocking member BK may be disposed to overlap the bank BNL, the first organic layer FOL, and the partition wall PW, and may not overlap the emission areas EA1, EA2, and EA3.

In an embodiment, the light blocking member BK may include an organic light blocking material and may be formed through a coating and exposure process of the organic light blocking material. The light blocking member BK may include a dye or pigment having light blocking properties and may be a black matrix. At least a portion of the light blocking member BK may overlap with adjacent color filters CF1, CF2, and CF3, and the color filters CF1, CF2, and CF3 may be disposed on at least a portion of the light blocking member BK.

A protective layer PTL may be disposed on the plurality of color filters CF1, CF2, and CF3 and the light blocking member BK. The first protective layer PTL may be disposed at the top of the display device 10 and may protect the plurality of color filters CF1, CF2, and CF3 and the light blocking member BK below. One surface, for example, a bottom surface, of the protective layer PTL may contact the plurality of color filters CF1, CF2, and CF3 and the upper surface of the light blocking member BK, respectively.

The protective layer PTL may include an inorganic insulating material to protect the plurality of color filters CF1, CF2, and CF3 and the light blocking member BK. For example, the first protective layer PTL may include silicon oxide (SiOx), silicon nitride (SiNx), silicon oxynitride (SiOxNy), aluminum oxide (AlxOy), aluminum nitride (AIN), and the like but is not limited to. The first protective layer PTF1 may have a predetermined thickness, for example, in the range of 0.01 to 1 µm. However, embodiments of the present disclosure are not limited thereto.

Referring to FIGS. 5 and 6, the light emitting element LE is illustrated as a vertical light emitting element LE, but embodiments of the present disclosure are not limited thereto and the light emitting element LE may be a flip-type light emitting element.

Hereinafter, a manufacturing device for a display panel that pressurizes and attaches a plurality of light emitting elements LE, namely micro LED, disposed on the pixel electrodes PE1, PE2, and PE3 of the display substrate 20 will be described in detail.

FIG. 7 is a side cross-sectional view schematically illustrating a manufacturing device for a display panel according to an embodiment. FIG. 8 is a front view schematically illustrating a top surface of the device for manufacturing the display panel illustrated in FIG. 7.

Referring to FIGS. 7 and 8, the manufacturing device for the display panel may bond two or more bonding objects to each other using a laser beam. The bonding objects may be a substrate, a film, a display panel, a touch panel, or a semiconductor element such as, for example, a printed circuit board, a flexible circuit board, or a light emitting element. Hereinafter, an example in which a first bonding object is the display substrate 20 and a second bonding object is the light emitting element LE will be described.

The device for manufacturing a display panel may include a support portion 200, a pressing portion 300, and a laser emission portion 500. The display panel manufacturing device may further include a mounting member 400.

The support portion 200 has a top surface parallel to a plane defined by a first direction DR1 and a second direction DR2 perpendicular to each other, and a display substrate 20 having a plurality of light emitting elements LE arranged on the top surface is mounted.

The support portion 200 may be a loading plate and may be formed in a polygonal flat plate shape such as, for example, a square or rectangular shape. In some aspects, the support portion 200 may be formed in a circular, oval, or other planar plate shape. Hereinafter, an example in which the support portion 200 is formed in the shape of a square flat plate shape will be described. In an embodiment, the support portion 200 may fix the display substrate 20.

The laser emission portion 500 is disposed in front of the light transmitting plate 310, which will be described later, and the laser emission portion 500 emits laser light and irradiates the display substrate 20 with the laser light, through the light transmitting plate 310. The laser emission portion 500 may be disposed on the uppermost surface of the manufacturing device. The laser emission portion 500 emits laser light in the direction of the support portion 200 on the lower surface, and the light emitted from the laser emission portion 500 is applied to a plurality of light emitting elements LE arranged on the display substrate 20.

The laser emission portion 500 may include a laser light source 510 and an optical system 530. The laser emission portion 500 may be referred to as a laser irradiation component, a laser irradiator, a laser emission component, a laser emitter, or the like.

The laser light source 510 is a device capable of generating laser light by externally supplied energy and may be configured to generate laser light, such as, for example, a solid-state laser, such as, for example, a YAG laser, ruby laser, glass laser, YVO4 laser, LD laser, fiber laser, liquid laser, such as, for example, a pigment laser, CO₂ laser, excimer laser (ArF laser, KrF laser, XeCl laser, XeF laser, or the like), gaseous laser, such as, for example, an Ar laser, He-Ne laser, semiconductor laser, free-electron laser, or the like.

The optical system 530 may include a plurality of lenses. The optical system 530 may receive beam-shaped laser light from the laser light source 510 and perform optical dispersion to enable area heating for a predetermined area.

The laser light emitted from the optical system 530 may irradiate the light emitting elements LE arranged on the display substrate 20 mounted on the support portion 200 and may heat a predetermined area of the light emitting elements LE.

The pressing portion 300 may be spaced apart from the support portion 200 in the third direction DR3 and may be disposed on the front of the support portion 200. The pressing portion 300 may press the display substrate 20 and the light emitting element LE on the support portion 200.

The pressing portion 300 may include a light transmitting plate 310, a plate transfer member 320, a reflective member 330, and a light absorbing member 340.

The light transmitting plate 310 is configured to transmit light of a target wavelength. For example, the light transmitting plate 310 allows laser light to travel to the front or back side in the opposite direction. The light transmitting plate 310 is formed in the form of a transparent or translucent flat plate, including at least one transparent material such as, for example, glass, quartz, silicon, or the like.

The light transmitting plate 310 is engaged with the plate transfer member 320 on at least one of its front and rear outer surfaces. The translucent plate 310 is attached (tied) when the plate transfer member 320 of the face is attached so that at least one of the outer portions of the front and rear faces thereof is located on the side thereof. Referring to Figs. 7 and 8, the plate transfer member 320 is attached at the outermost portion of the front surface of the translucent plate 310 in plan view, and a portion of the front surface of the translucent plate 310, excluding the outermost portion, is surrounded by the plate transfer member 320 with the portion exposed on the front side. the plate transfer member 320 is formed in a square ring shape in plan view to match the square flat plate shapes of the display substrate 20, the translucent plate 310, the laser emission portion (or laser irradiation section) 500, and the like.

The plate transfer member 320 may fix the light transmitting plate 310 and may be movable in the third direction DR3. Accordingly, the light transmitting plate 310 may be moved by the plate transfer member 320 in a direction toward the display substrate 20 that approaches the display substrate 20 or in an opposite direction away from the display substrate 20. The light transmitting plate 310 moves in the direction toward the display substrate 20, and approaching the display substrate 20, by the plate transfer member 320 in association with pressing the plurality of light emitting elements LE arranged on the display substrate 20 toward the display substrate 20.

The plate transfer member 320 is disposed on at least one side of the light transmitting plate 310 and is engaged at least one of the front and rear outer surfaces of the light transmitting plate 310.

The plate transfer member 320 includes at least one transfer module and may be moved in a direction toward the support portion 200 that is closer to the support portion 200 or in an opposite direction away from the support portion 200 by at least one transfer module. Accordingly, the plate transfer member 320 is engaged with the light transmitting plate 310 disposed on the front of the support portion 200 and moves the light transmitting plate 310 in the direction toward the display substrate 20, and closer to the display substrate 20, or in an opposite direction away from the display substrate 20. This plate transfer member 320 may move the light transmitting plate 310 toward the display substrate 20 such that the light transmitting plate 310 presses the plurality of light emitting elements LE arranged on the display substrate 20 onto the display substrate 20. The transfer module of the plate transfer member 320 may include at least one conveyor, motor, chain, roller, gear, or the like.

The reflective member 330 may be disposed within the light transmitting plate 310 to change the reflection path of the laser light applied from the laser emission portion 500. For example, the reflective member 330 may be embedded in an outer area of the light transmitting plate 310 that corresponds to the non-display area NDA, which is an outer area of the light transmitting plate 310, except for the display area DPA of the display substrate 20 where the plurality of light emitting elements LE are arranged.

In an embodiment, the reflective member 330 may be embedded in and integrally formed with the light transmitting plate 310. The reflective member 330 may include one or more mirrors. The mirror may have a preset tilt in the direction in which the light absorbing member 340 is disposed.

In an embodiment, the reflective member 330 is formed of a material that reflects light (e.g., aluminum), and the first reflective member 331, the second reflective member 332, and may include a first reflective member 331, a second reflective member 332, and a third reflective member 333. The first reflective member 331, the second reflective member 332, and the third reflective member 333 may be sequentially disposed from the inside to the outside of the light transmitting plate 310. For example, the third reflective member 333 may be disposed on the outermost side of the light transmitting plate 310.

The first reflective member 331 defines one opening corresponding to the transmission area of the laser beam, and the transmission area of the laser beam may correspond to the display area DPA.

Here, the light emitted from the laser emission portion 500 penetrates one opening corresponding to the display area DPA of the display substrate 20 and is applied to the plurality of light emitting elements LE arranged on the display substrate 20.

The first reflective member 331 may be formed in the shape of a triangular mountain with a triangular cross-section. Here, the cross-section of the first reflective member 331 may be formed as a triangular shape among a right triangle, an equilateral triangle, and an isosceles triangle. In some aspects, a front surface of the first reflective member 331 is inclined at a preset inclination in the direction in which the neighboring second reflective member 332 is disposed. Referring to Fig. 7, the first reflective member 331 has a right triangle shape with a surface that is generally perpendicular to the first inner surface 310a in cross-sectional view, and the inclined surface of said right triangle faces outward and said inclined surface is facing the second reflective member 332. The laser beam irradiated from the laser emission portion 500 and incident on this inclined surface of the first reflective member 331 is reflected toward the second reflective member 332. The laser light that is not reflected by the first reflective member 331 is transmitted to the display substrate 20. In other words, the first reflective member 331 defines the transmission area aperture. Specifically, referring to Fig. 7, the transmission area aperture is defined by the innermost portion of the first reflective member 331. the vertical plane of the innermost portion of the first reflective member 331 is generally perpendicular to the first inner side (or first inner surface) 310a, so that the laser beam can generally travel straight toward the light emitting element LE of the display substrate 20 in the transmission area aperture and can irradiate the laser beam generally accurately targeting the light emitting element LE. The laser beam can be aimed at the light-emitting element LE.

The second reflective member 332 is disposed outside the first reflective member 331, and the third reflective member 333 is disposed to face the second reflective member 332 and may be disposed outwardly from the second reflective member 332. The first, second, and third reflective members 331-333 are arranged to reflect the laser light reflected at the first reflective member 331 toward the outside.

For example, the light transmitting plate 310 may include first to fourth inner surfaces (or inner sides) 310a, 310b, 310c, and 310d, and each corner may be vertically connected. The first reflective member 331 may be disposed on the first inner surface 310a, and the second reflective member 332 may be disposed on the second inner surface 310b facing the first inner surface 310a. The third reflective member 333 is disposed on the first inner surface 310a and may be disposed further outside the first reflective member 331. The second reflective member 332 and the third reflective member 333 may partially overlap in the thickness direction of the light transmitting plate 310. Specifically, in Fig. 7, the first reflective member 331 is arranged on the first inner side 310a such that the right-angled triangular bottom surface is aligned with the first inner side 310a in cross-sectional view, the vertical surface is generally orthogonal to the first inner side 310a, and the inclined surface is inclined toward the outer side from the inside so that the height in its third direction DR3 can be disposed inclined with respect to the first inner side 310a so that the lower the inner side is, the lower the height of the third direction DR3. The second reflective member 332 can be rectangular in cross-sectional view and disposed generally flush with the second inner side 310b such that the upper surface is aligned with the second inner side 310b and the lower surface can reflect the laser light reflected by the first reflective member 331 outwardly along the second inner side 310b within the translucent plate 310. The third reflective member 333 can be arranged to reflect the laser light reflected by the first reflective member 331 outwardly along the second inner side 310b in the translucent plate 310. The third reflective member 333 can be rectangular in cross-sectional view and arranged so that the lower surface is generally flush with the first inner side 310a and the upper surface can reflect the laser light reflected by the second reflective member 332 outwardly along the first inner side 310a within the translucent plate 310. The top surface can be arranged to reflect the laser light reflected by the second reflective member 332 outwardly along the first inner side 310a in the translucent plate 310.

In this way, the first reflective member 331 defines the transmission zone LTZ of the laser beam on the display substrate 20, and the second reflective member 332 and the third reflective member 333 may serve as light guides to direct the path of light reflected by the first reflective member 331.

The light absorbing member 340 may be disposed on the reflection path of the laser light and may absorb the laser light reflected from the reflective member 330. For example, the light absorbing member 340 may be disposed closer to the third reflective member 333 than to the first reflective member 331.

The light absorbing member 340 may be disposed on one side of the plate transfer member 320 by the mounting member 400 coupled to the plate transfer member 320 and may be simultaneously moved in the same direction as the plate transfer member 320.

The light absorbing member 340 is disposed on the reflection path of the laser light by the mounting member 400 and may be disposed on one side of the light transmitting plate 310.

According to one embodiment, the laser light applied to the first reflective member 331 of the light transmitting plate 310 proceeds to the second reflective member 332 by the tilt of the first reflective member 331, and the laser light proceeding to the second reflective member 332 proceeds in the direction of the light absorbing member 340. Accordingly, the laser light emitted from the laser emission portion 500 may be transmitted through the openings of the first reflective member 331 and applied to the plurality of light emitting elements LE arranged on the display substrate 20. In other words, in some example aspects, only the laser light that passes through the opening of the first reflective member 331 is applied to the plurality of light emitting elements LE arranged on the display substrate 20.

The length of the outer portion of the light transmitting plate 310 may be reduced by the second reflective member 332, which serves as a light guide. The outer portion of the light transmitting plate 310 may be a distance between the display substrate 20 and the plate transfer member 320 in the same plane.

Since the outer portion of the light transmitting plate 310 is shortened, the possibility of deformation of the light transmitting plate 310 when pressed may be minimized. Accordingly, the uniformity of the pressing force applied to the display substrate 20 may increase.

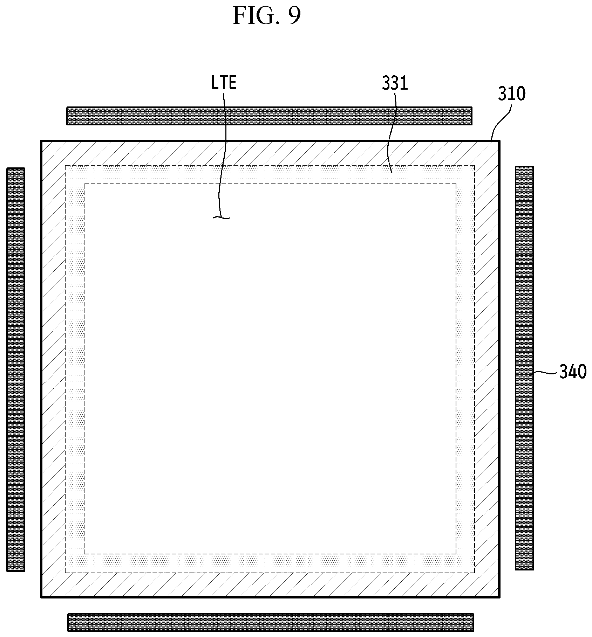

FIG. 9 is a front view illustrating the arrangement shape of the first reflective member and the light absorbing member illustrated in FIGS. 7 and 8.

Referring to FIG. 9, the first reflective member 331 is embedded in an outer area of the light transmitting plate 310. The outer area of the light transmitting plate 310 may correspond to the non-display area, which is the outer area of the display substrate 20 illustrated in FIGS. 7 and 8.

The first reflective member 331 may be embedded in an outer area of the light transmitting plate 310 that corresponds to the non-display area NDA, which is an outer area of the display substrate 20, except for the display area DPA of the display substrate 20 where the plurality of light emitting elements LE are arranged.

The first reflective member 331 may include openings corresponding to the laser beam transmission zone LTZ in the display substrate 20.

The light absorbing member 340 may be disposed to be spaced apart from the light transmitting plate 310 and may be disposed on each side of the light transmitting plate 310. The light absorbing member 340 may be arranged to surround the first reflective member 331.

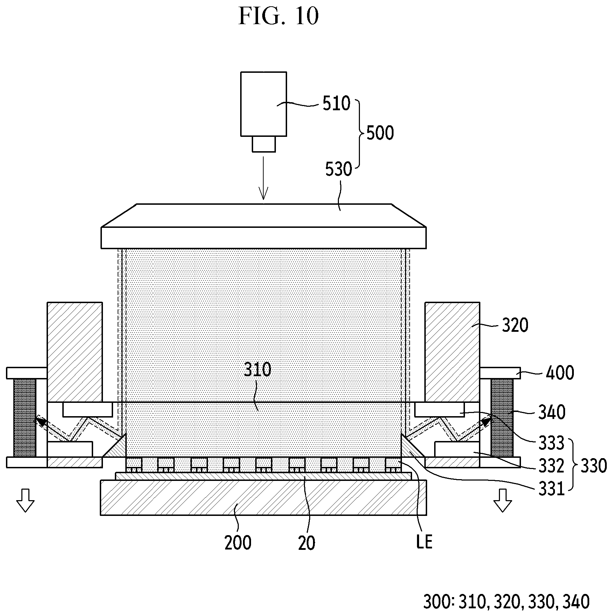

FIG. 10 is a cross-sectional view of one side illustrating a micro LED transfer method using a manufacturing device in an embodiment.

Referring to FIG. 10, first, a plate transfer member 320 may first be engaged with a light transmitting plate 310 disposed on a front surface of the support portion 200 to move the light transmitting plate 310 toward the display substrate 20 in proximity to the display substrate 20.

The plate transfer member 320 may move the light transmitting plate 310 toward the display substrate 20 in association with pressing the plurality of light emitting elements LE arranged on the display substrate 20 with the light transmitting plate 310 onto the display substrate 20.

Thereafter, the plate transfer member 320 may move the light transmitting plate 310 in the opposite direction away from the display substrate 20.

In some embodiments, the laser emission portion 500 emits laser light and irradiates the display substrate 20 with the laser light, through the light transmitting plate 310. In particular, the laser emission portion 500 radiates laser light in the direction of the support portion 200 on the lower surface, and the light emitted from the laser emission portion 500 penetrates the openings of the first reflective member 331 and is applied to the plurality of light emitting elements LE arranged on the display substrate 20.

In some embodiments, the laser light applied to the first reflective member 331 of the light transmitting plate 310 is reflected toward the second reflective member 332 by the tilt of the first reflective member 331. The light incident on the second reflective member 332 is reflected by the second reflective member 332 and is reflected in the direction of the third reflective member 333 disposed to face the light. The light incident on the third reflective member 333 is reflected by the third reflective member 333 and is reflected in the direction of the light absorbing member 340.

Accordingly, among the laser light emitted from the laser emission portion 500, the light transmitted through the openings of the first reflective member 331 may be applied to the plurality of light emitting elements LE arranged on the display substrate 20. In some embodiments, the laser light reflected by the second reflective member 332 and the third reflective member 333 proceeds to the light absorbing member 340 and is absorbed by the light absorbing member 340.

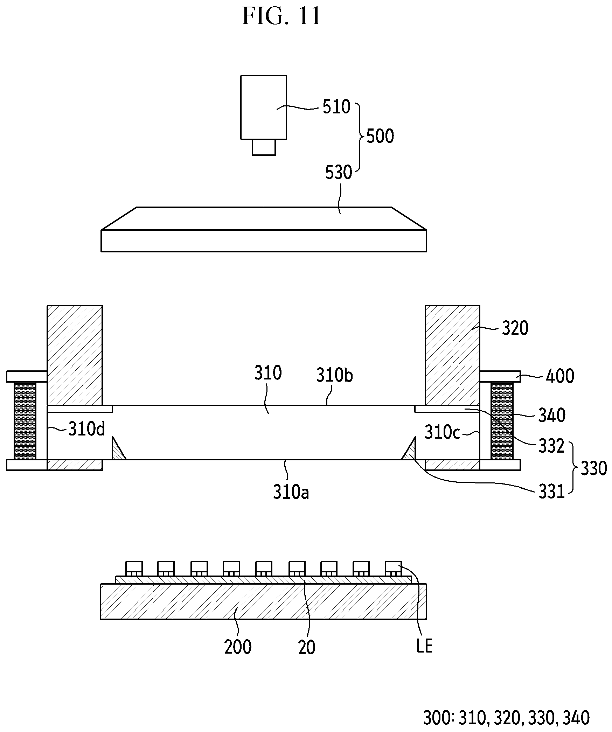

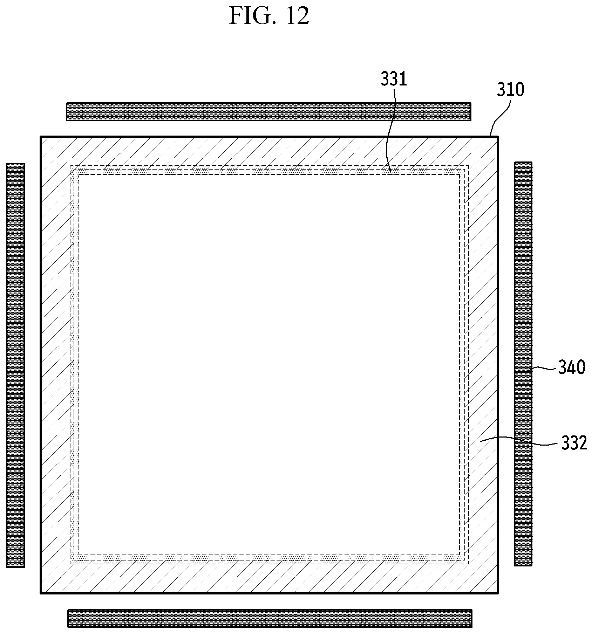

FIG. 11 is a cross-sectional view of one side schematically illustrating a display panel manufacturing device according to another embodiment. FIG. 12 is a front view illustrating the arrangement shape of the first reflective member, the second reflective member, and the light absorbing member illustrated in FIG. 11.

Referring to FIGS. 11 and 12, the orientation of the inclined surface of the first reflective member 331 and the number of reflective members differ from the manufacturing device for the display panel described with reference to FIGS. 7 to 10. Descriptions overlapping with the embodiments of FIGS. 7 to 10 will be omitted.

Referring to FIG. 11, the reflective member 330 may be embedded in an outer area of the light transmitting plate 310 that corresponds to the non-display area NDA, which is an outer area of the light transmitting plate 310, except for the display area DPA of the display substrate 20 where the plurality of light emitting elements LE are arranged.

In an embodiment, the reflective member 330 may be embedded in and integrally formed with the light transmitting plate 310. The reflective member 330 may include one or more mirrors. The mirror may have a preset tilt in the direction in which the light absorbing member 340 is disposed.

In an embodiment, the reflective member 330 is formed of a material that reflects light (e.g., aluminum) and may include a first reflective member 331 and a second reflective member 332. The first reflective member 331 and the second reflective member 332 may be sequentially disposed from the inside to the outside of the light transmitting plate 310. For example, the third reflective member 333 may be disposed on the outermost side of the light transmitting plate 310.

The first reflective member 331 defines one opening corresponding to the laser beam transmission zone LTZ, and the laser beam transmission area may correspond to the display area DPA.

Here, the light emitted from the laser emission portion 500 penetrates one opening corresponding to the display area DPA of the display substrate 20 and is applied to the plurality of light emitting elements LE arranged on the display substrate 20.

The first reflective member 331 may be formed in the shape of a triangular mountain with a triangular cross-section. Here, the cross-section (triangular cross-section) of the first reflective member 331 may be formed as a triangular shape among a right triangle, an equilateral triangle, and an isosceles triangle. In some aspects, a side of the first reflective member 331 in the front direction is formed to be inclined at a predetermined slope in the direction in which the second reflective member 332 is disposed. For example, the first reflective member 331 may have a right triangle in cross section and be disposed with its hypotenuse facing the center of the light transmitting plate 310.

While the inclined surface of the first reflective member 331 described with reference to FIGS. 7 to 11 is disposed toward the outside of the light transmitting plate 310, the inclined surface of the first reflective member 331 described with reference to FIG. 12 is disposed toward the outside of the light transmitting plate 310. The second reflective member 332 may be disposed outside the first reflective member 331.

For example, the light transmitting plate 310 may include first to fourth inner surfaces 310a, 310b, 310c, and 310d, and each corner may be vertically connected. The first reflective member 331 may be disposed on the first inner surface 310a, and the second reflective member 332 may be disposed on the second inner surface 310b facing the first inner surface 310a.

In this way, the first reflective member 331 may define the transmission zone LTZ of the laser beam on the display substrate 20, and the second reflective member 332 may serve as a light guide to direct the path of light reflected by the first reflective member 331.

The light absorbing member 340 may be disposed on the reflection path of the laser light, not overlapping with the light path irradiated by the laser emission portion 500 and may absorb the laser light reflected from the reflective member 330. For example, the light absorbing member 340 may be disposed closer to the second reflective member 333 than to the first reflective member 331.

The light absorbing member 340 may be disposed on one side of the plate transfer member 320 by the mounting member 400 coupled to the plate transfer member 320 and may be simultaneously moved in the same direction as the plate transfer member 320.

The light absorbing member 340 is disposed on the reflection path of the laser light by the mounting member 400 and may be disposed on one side of the light transmitting plate 310.

According to one embodiment, the laser light applied to the first reflective member 331 of the light transmitting plate 310 proceeds to the second reflective member 332 by the tilt of the first reflective member 331, and the second reflective member 332 proceeds in the direction of the light absorbing member 340. Accordingly, the laser light emitted from the laser emission portion 500 may be transmitted through the openings of the first reflective member 331 and applied to the plurality of light emitting elements LE arranged on the display substrate 20. That is, in some example aspects, only the laser light that passes through the opening of the first reflective member 331 is applied to the plurality of light emitting elements LE arranged on the display substrate 20.

The length of the outer portion of the light transmitting plate 310 may be reduced by the second reflective member 332, which serves as a light guide. The outer portion of the light transmitting plate 310 may be the distance between the display substrate 20 and the plate transfer member 320 on the same plane.

Since the outer portion of the light transmitting plate 310 is shortened, the possibility of deformation of the light transmitting plate 310 when pressed may be minimized. Accordingly, the uniformity of the pressing force applied to the display substrate 20 may increase.

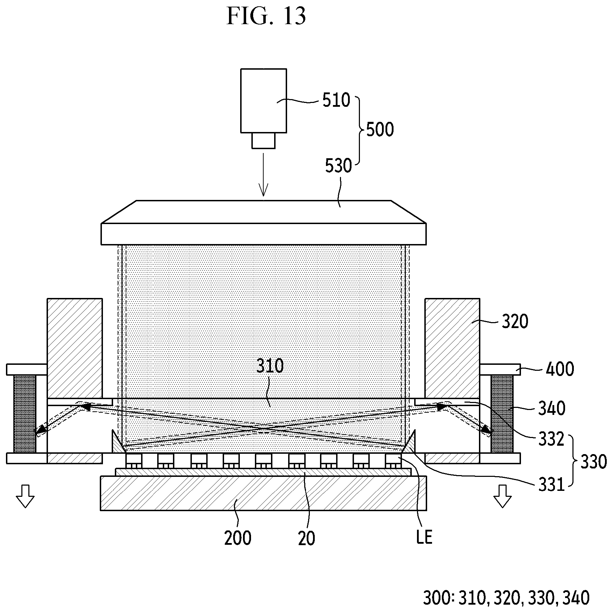

FIG. 13 is a cross-sectional view of one side illustrating a micro LED transfer method using the manufacturing device of FIG. 12.

Referring to FIG. 13, first, a plate transfer member 320 may first be engaged with a light transmitting plate 310 disposed on a front surface of the support portion 200 to move the light transmitting plate 310 toward the display substrate 20 in proximity to the display substrate 20.

The plate transfer member 320 may move the light transmitting plate 310 toward the display substrate 20 in association with pressing the plurality of light emitting elements LE arranged on the display substrate 20 with the light transmitting plate 310 onto the display substrate 20.

Thereafter, the plate transfer member 320 may move the light transmitting plate 310 in the opposite direction away from the display substrate 20.

In some embodiments, the laser emission portion 500 emits laser light and irradiates the display substrate 20 with the laser light, through the light transmitting plate 310. In particular, the laser emission portion 500 radiates laser light in the direction of the support portion 200 on the lower surface, and the light emitted from the laser emission portion 500 penetrates the openings of the first reflective member 331 and is applied to the plurality of light emitting elements LE arranged on the display substrate 20.

In some embodiments, the laser light applied to the first reflective member 331 of the light transmitting plate 310 is reflected toward the second reflective member 332 by the tilt of the first reflective member 331.

Since the inclined surface of the first reflective member 331 is disposed in the inner direction of the light transmitting plate 310, the light reflected by the first reflective member 331 passes through the laser beam transmission zone LTZ and is incident on the second reflective member 332. The light incident on the second reflective member 332 is reflected by the second reflective member 332 and is reflected in the direction of the light absorbing member 340.

Accordingly, in some example aspects, among the laser light emitted from the laser emission portion 500, the light transmitted through the openings of the first reflective member 331 may be applied to the plurality of light emitting elements LE arranged on the display substrate 20. In some embodiments, the laser light reflected by the second reflective member 332 travels to the light absorbing member 340 and is absorbed by the light absorbing member 340.

Among the laser light emitted from the laser emission portion 500, the light transmitted through one opening corresponding to the display area DPA of the display substrate 20 may be applied to the plurality of light emitting elements LE arranged on the display substrate 20. That is, the laser light that passes through the opening corresponding to the display area DPA may be applied to the plurality of light emitting elements LE arranged on the display substrate 20.

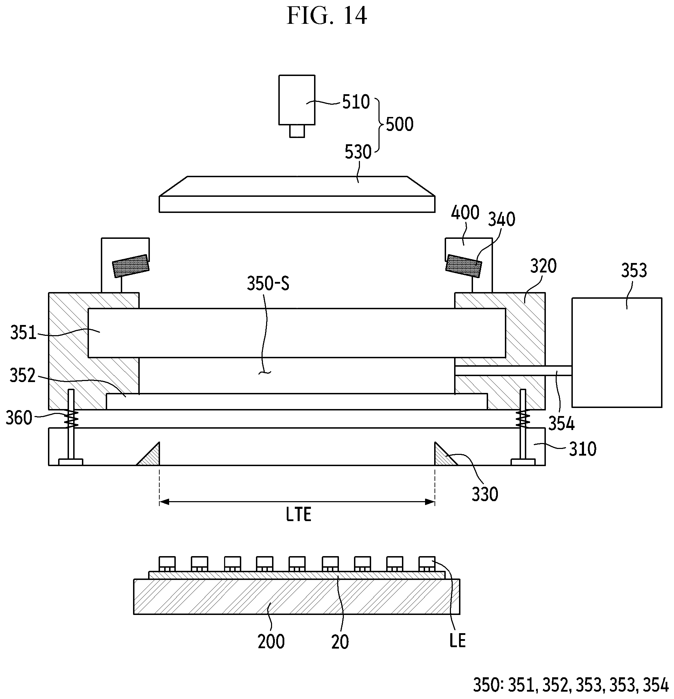

FIG. 14 is a side cross-sectional view schematically illustrating a display panel manufacturing device according to another embodiment.

Referring to FIG. 14, the device for manufacturing the display panel described with reference to FIGS. 7 to 10 differs from the device for manufacturing the display panel described with reference to FIGS. 7 to 10 in that the pressing portion 300 further includes a pressing member 350 and a buffer member 360, and a light absorbing member 340 is disposed on the plate transfer member 320. Descriptions overlapping with the embodiments of FIGS. 7 to 10 will be omitted.

Referring to FIG. 14, a device for manufacturing a display panel may include a support portion 200, a pressing portion 300, and a laser emission portion 500. The display panel manufacturing device may further include a mounting member 400.

The pressing portion 300 includes a light transmitting plate 310, a plate transfer member 320, a reflective member 330, and a light absorbing member 340, and may include a pressing member 350 and a buffer member 360.

The light transmitting plate 310 allows laser light to travel to the front or back side in the opposite direction. The light transmitting plate 310 is formed in the form of a transparent or translucent flat plate, including at least one transparent material such as, for example, glass, quartz, silicon, or the like.

At least one of the front and rear outer surfaces of the light transmitting plate 310 is coupled to the plate transfer member 320 on the side.

The plate transfer member 320 may fix the light transmitting plate 310 and may be movable in the third direction DR3. Accordingly, the light transmitting plate 310 may be moved by the plate transfer member 320 in a direction toward the display substrate 20 that approaches the display substrate 20 or in an opposite direction away from the display substrate 20. The light transmitting plate 310 may be moved by the plate transfer member 320 in a direction toward the display substrate 20 that is closer to the display substrate 20 such that the light transmitting plate 310 presses the plurality of light emitting elements LE arranged on the display substrate 20 toward the display substrate 20.

The plate transfer member 320 may be attached to the outer front surface of the light transmitting plate 310 through the buffer member 360.

The buffer member 360 is a component that acts as a buffer to offset the self-weight of the pressing member 350 by pressing the pressing member 350 in the reverse direction, and may be implemented by, for example, an air cylinder or an elastic spring. Therefore, the buffer member 360 cancels the basic self-weight of the pressing member 350 to zero 0 and then stands by to press the pressing member 350.

The plate transfer member 320 includes at least one transfer module and may be moved in a direction toward the support portion 200 that is closer to the support portion 200 or in an opposite direction away from the support portion 200 by at least one transfer module. Accordingly, the plate transfer member 320 is coupled to the light transmitting plate 310 disposed on the front of the support portion 200 to move the light transmitting plate 310 in a direction toward the display substrate 20 that approaches the display substrate 20 or in an opposite direction away from the display substrate 20. Such a plate transfer member 320 may move the light transmitting plate 310 in the direction toward the display substrate 20 such that the light transmitting plate 310 presses the plurality of light emitting elements LE arranged on the display substrate 20 onto the display substrate 20. The transfer module of the plate transfer member 320 may include at least one conveyor, motor, chain, roller, gear, or the like.

The reflective member 330 may be disposed within the light transmitting plate 310 to change the reflection path of the laser light applied from the laser emission portion 500. For example, the reflective member 330 may be embedded in an outer area of the light transmitting plate 310 that corresponds to the non-display area NDA, which is an outer area of the display substrate 20 excluding the display area DPA of the display substrate 20 where the plurality of light emitting elements LE are arranged.

In an embodiment, the reflective member 330 may be built into the light transmitting plate 310 and formed integrally with the light transmitting plate 310. The reflective member 330 may be formed of a material that reflects light (e.g., aluminum). The reflective member 330 may be formed in the shape of a triangular mountain with a triangular cross-section. Here, the cross-section of the reflective member 330 may be formed as a triangular shape selected from the group consisting of a right triangle, an equilateral triangle, and an isosceles triangle, and a side of the front surface of the reflective member may be inclined at a preset inclination in the direction in which the light absorbing member 340 is disposed.

The reflective member 330 may be embedded in an outer area of the light transmitting plate 310 that corresponds to the non-display area NDA, which is an outer area of the display substrate 20.

The reflective member 330 may define one opening corresponding to the transmission area of the laser beam, and the transmission area of the laser beam may correspond to the display area DPA.

Here, the light emitted from the laser emission portion 500 penetrates one opening corresponding to the display area DPA of the display substrate 20 and is applied to the plurality of light emitting elements LE arranged on the display substrate 20.

The light absorbing member 340 may be disposed on the reflection path of the laser light and may absorb the laser light reflected from the reflective member 330.

The light absorbing member 340 is disposed on one side of the plate transfer member 320 by the mounting member 400 coupled to the plate transfer member 320 and may be moved simultaneously in the same direction as the plate transfer member 320.

The mounting member 400 may be disposed farther from the support portion 200 than the plate transfer member 320. For example, the mounting member 400 may be attached to the front of the plate transfer member 320. Because of this, the light absorbing member 340 may be disposed on the first light transmitting member 351.

The light absorbing member 340 may be disposed in the direction in which the reflective member 330 is disposed by the mounting member 400 and may be disposed inclined at a preset inclination in the direction in which the reflective member 330 is disposed.

The pressing member 350 may include a first light transmitting member 351, a second light transmitting member 352, a gas pressure adjustment member 353, and a gas conduit 354.

The pressing member 350 may include a closed space 350-S between the first light transmitting member 351 and the second light transmitting member 352.

The first light transmitting member 351 and the second light transmitting member 352 may be arranged in a straight line to overlap in the thickness direction.

The pressing member 350 may be coupled to the plate transfer member 320 and may move in a direction toward the display substrate 20 that approaches the display substrate 20 or in an opposite direction away from the display substrate 20.

The first light transmitting member 351 may be formed as a rectangular plane having a long side in a first direction and a short side in a second direction that intersects the first direction. A corner where the long side in the first direction and the short side in the second direction meet may be formed at a right angle. The planar shape of the first light transmitting member 351 and the second light transmitting member 352 is not limited to a square shape, but may be formed as any other polygonal, circular, or elliptical shape.

The first light transmitting member 351 may formed of a rigid light transmitting material and may pass the laser light emitted from the laser emission portion 500. Here, light transmission may be defined as being able to pass more than 80% of the light energy of the laser light emitted from the laser emission portion 500. For example, the first light transmitting member 351 may be formed of a material capable of exhibiting a light transmittance of about 80% or more for light in a wavelength range of about 250 nm to 5 µm but is not limited thereto.

In some aspects, the first light transmitting member 351 may be formed of any material capable of withstand a pressure inside the closed space 350-S, for example, a pressure of about 0.1 MPa to about 5 MPa based on the gauge pressure. The first light transmitting member 351 may be formed of a material such as, for example, tempered glass, quartz, acrylic, an oxide of a metal or an oxide of a semi-metal, such as, for example, silicon oxide, aluminum oxide, or the like. However, the first light transmitting member 351 is not limited thereto.

The second light transmitting member 352 is formed of an elastic, light transmitting material and may pass the laser light emitted from the laser emission portion 500. For example, the second light transmitting member 352 may be formed of a silicon multi-layer, a silicon-PET (polyethylene terephthalate) laminated layer, or the like. However, the second light transmitting member 352 is not limited thereto.

The second light transmitting member 352 expands in a downward direction, that is, in the direction toward the light transmitting plate 310, due to the pressure inside the closed space 350-S, thereby generating a pressing force in the downward direction.

The gas pressure adjustment member 353 may generate pressing force by supplying gas to the closed space 350-S between the first light transmitting member 351 and the second light transmitting member 352.

The gas pressure adjustment member 353 may supply a gas into the closed space 350-S that is inert or extremely chemically reactive and capable of transmitting a laser beam, such as, for example, nitrogen (N2), helium (He), neon (Ne), argon (Ar), carbon dioxide (CO₂), or mixtures thereof. Hereinafter, gases that are inert or have extremely low chemical reactivity are collectively referred to as neutral gas.

The gas pressure adjustment member 353 may include a reservoir for storing gas, a gas pump for pressurizing and supplying the gas, and a gas valve for controlling the flow of the gas. The gas pump may be configured to supply gas into the closed space 350-S at an increased pressure compared to the external pressure of the closed space 350-S.

The gas valve may stop the supply of gas when the pressure inside the closed space 350-S is sufficiently high and close the closed space 350-S such that the pressure inside the closed space 350-S is maintained. The gas valve may be, for example, a ball valve, a globe valve, a gate valve, a control valve, or the like.

The gas conduit 354 connects between the gas pressure adjustment member 353 and the closed space 350-S and provides a path for gas to move. The gas may move between the gas pressure adjustment member 323 and the closed space 320-S by the gas conduit 354.

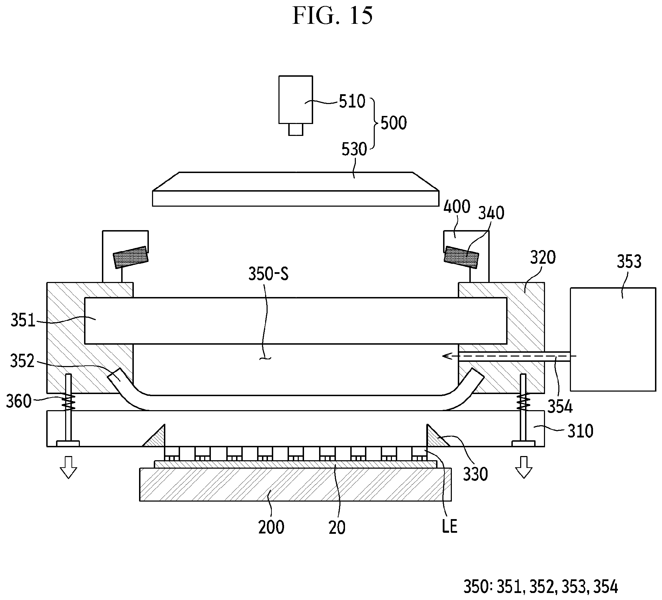

FIGS. 15 to 17 are cross-sectional views of one side illustrating a micro LED transfer method using the manufacturing device of FIG. 14.

Referring to FIG. 15, a plate transfer member 320 is coupled to the light transmitting plate 310 disposed on the front of the support portion 200 and may move the light transmitting plate 310 toward the display substrate 20 in proximity to the display substrate 20.

The gas pressure adjustment member 353 opens a gas valve to fill the closed space 350-S between the first light transmitting member 351 and the second light transmitting member 352 with gas through the gas conduit 354. As the gas is filled in the closed space 350-S, the pressure inside the closed space 350-S increases and expands in a downward direction, that is, in the direction toward the display substrate 20, generating a pressing force in the downward direction.

The second light transmitting member 352 expands downward by filling with gas, and a uniform pressure P may be applied to the surface of the light emitting element LE on the display substrate 20.

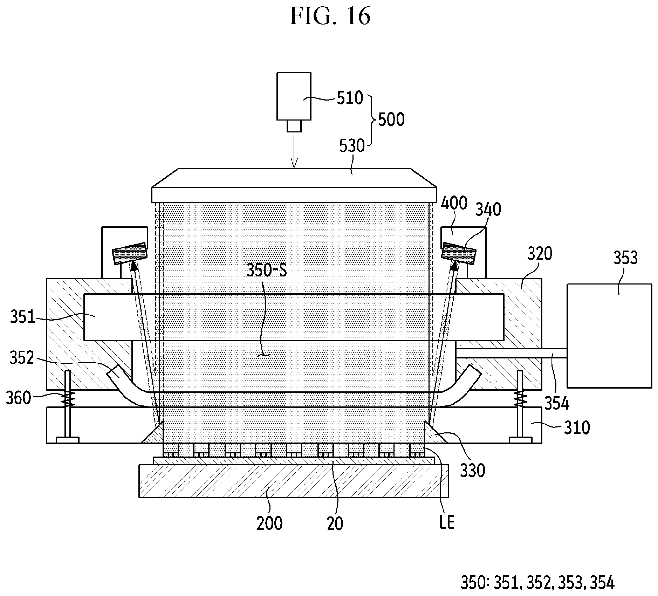

Referring to FIG. 16, the laser emission portion 500 emits laser light in the direction of the light transmitting plate 310 on the lower surface. Here, the light emitted from the laser emission portion 500 penetrates one opening corresponding to the display area DPA of the display substrate 20 and is applied to the plurality of light emitting elements LE arranged on the display substrate 20.

In some embodiments, the laser light applied to the reflective member 330 corresponding to the non-display area NDA of the display substrate 20 is reflected toward the light absorbing member 340 by the tilt of the reflective member 330. Accordingly, among the laser light emitted from the laser emission portion 500, the light transmitted through one opening corresponding to the display area DPA of the display substrate 20 may be applied to the plurality of light emitting elements LE arranged on the display substrate 20. That is, for example, only the laser light that passes through the opening corresponding to the display area DPA may be applied to the plurality of light emitting elements LE arranged on the display substrate 20.

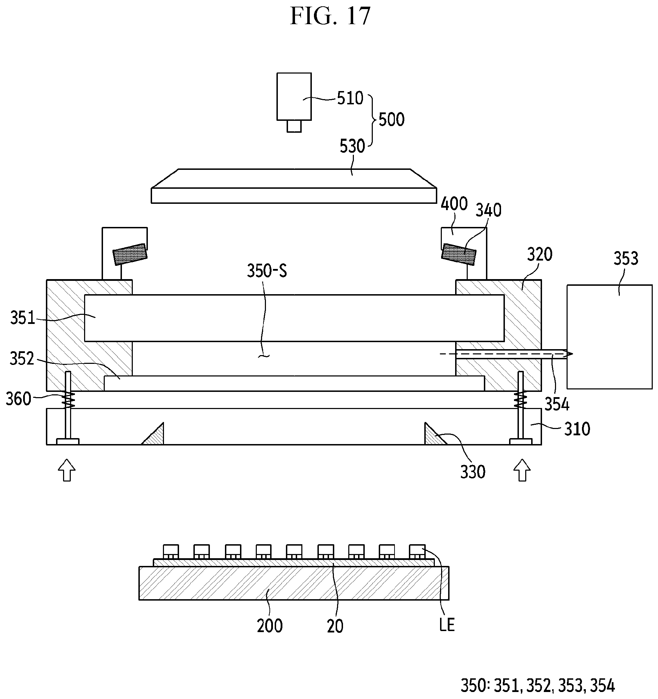

Referring to FIG. 17, when laser irradiation is completed by the laser emission portion 500, the gas pressure adjustment member 353 may lower the pressure of the closed space 350-S by discharging gas in the closed space 350-S. In an example in which the pressure of the closed space 350-S is lowered, the second light transmitting member 352, which was expanded downward, returns to its original state, thereby lowering the pressing force.

Thereafter, the plate transfer member 320 may move the light transmitting plate 310 in a direction away from the display substrate 20.

According to the embodiment described with reference to FIGS. **14** to 17, the first light transmitting member 351 may undergo a temperature change, which may cause thermal deformation or the like on its surface, and even in this case, the second light transmitting member 352 may be able to apply an even pressure in the downward direction.

According to one embodiment, even in the case of the display substrate 20 having a large area size, even pressure distribution is possible when bonding the light emitting element LE on the display substrate 20 using a laser.

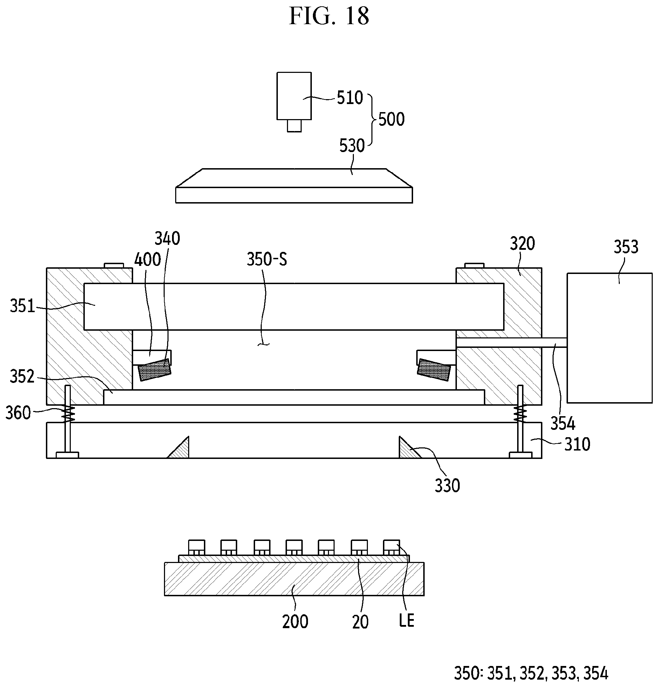

FIG. 18 is a side cross-sectional view schematically illustrating a display panel manufacturing device according to another embodiment.

Referring to FIG. 18, the mounting member 400 and the light absorbing member 340 differ from the manufacturing device for the display panel described with reference to FIGS. 14 to 17 in that the mounting member 400 and the light absorbing member 340 are disposed within a closed space 350-S between the first light transmitting member 351 and the second light transmitting member 352. Descriptions overlapping with the embodiments of FIGS. **14** to 17 will be omitted.

Referring to FIG. 18, the mounting member 400 is attached to the side of the plate transfer member 320 and is disposed between the first light transmitting member 351 and the second light transmitting member 352.

The light absorbing member 340 may be disposed on the reflection path of the laser light and may absorb the laser light reflected from the reflective member 330.

The light absorbing member 340 is disposed on one side of the plate transfer member 320 by the mounting member 400 coupled to the plate transfer member 320 and may be moved simultaneously in the same direction as the plate transfer member 320.

The light absorbing member 340 is disposed in the direction in which the reflective member 330 is disposed by the mounting member 400 and may be disposed at an inclination that is preset to face the direction in which the reflective member 330 is disposed.

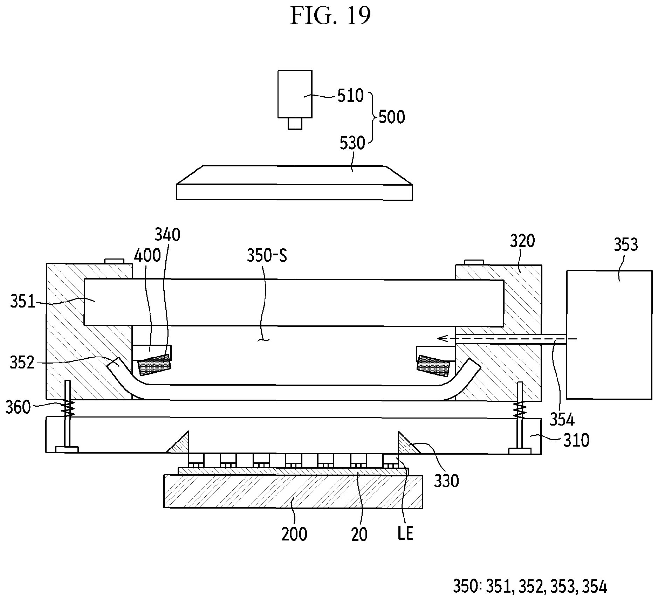

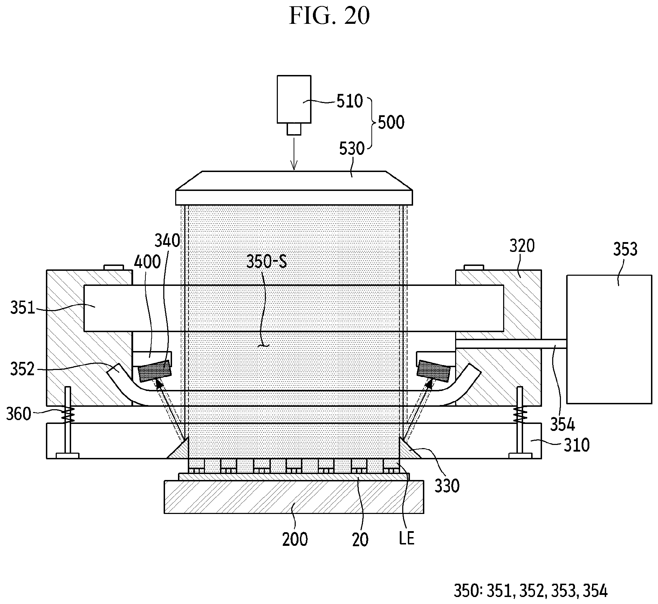

FIGS. 19 and 20 are cross-sectional views of one side illustrating a micro LED transfer method using the manufacturing device of FIG. 18.

Referring to FIG. 19, a plate transfer member 320 is coupled to the light transmitting plate 310 disposed on the front of the support portion 200 and may move the light transmitting plate 310 toward the display substrate 20 in proximity to the display substrate 20.

A gas pressure adjustment member 353 opens a gas valve to fill the closed space 350-S between the first light transmitting member 351 and the second light transmitting member 352 with gas through a gas conduit 354. As the gas is filled in the closed space 350-S, the pressure inside the closed space 350-S increases and expands in a downward direction, that is, in the direction toward the display substrate 20, generating a pressing force in the downward direction.

The second light transmitting member 352 expands downward by filling with gas, and a uniform pressure may be applied to the surface of the light emitting element LE on the display substrate 20.

Referring to FIG. 20, the laser emission portion 500 emits laser light in the direction of the light transmitting plate 310 on the lower surface. Here, the light emitted from the laser emission portion 500 penetrates one opening corresponding to the display area DPA of the display substrate 20 and is applied to the plurality of light emitting elements LE arranged on the display substrate 20.

In some embodiments, the laser light applied to the reflective member 330 corresponding to the non-display area NDA of the display substrate 20 is reflected toward the light absorbing member 340 by the tilt of the reflective member 330. Accordingly, among the laser light emitted from the laser emission portion 500, the light transmitted through one opening corresponding to the display area DPA of the display substrate 20 may be applied to the plurality of light emitting elements LE arranged on the display substrate 20. That is, for example, only the laser light that passes through the opening corresponding to the display area DPA may be applied to the plurality of light emitting elements LE arranged on the display substrate 20.

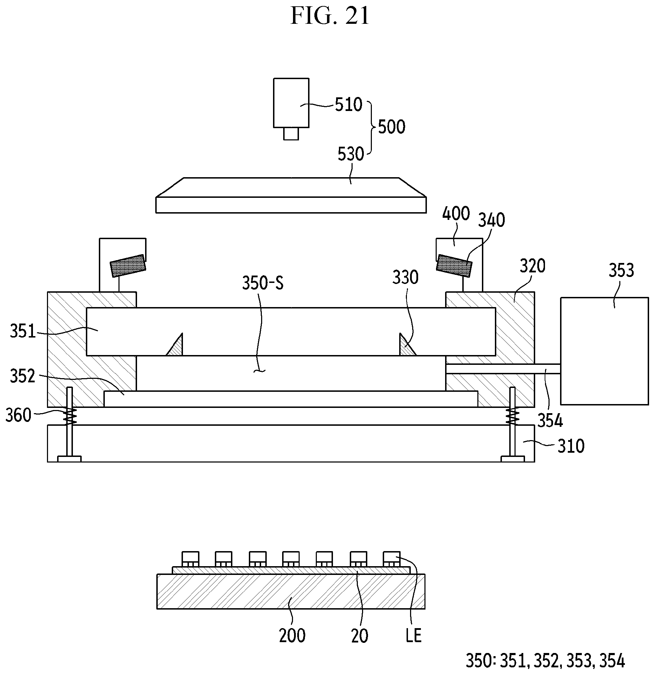

FIG. 21 is a side cross-sectional view schematically illustrating a display panel manufacturing device according to another embodiment.

Referring to FIG. 21, the device for manufacturing the display panel described with reference to FIGS. 14 to 17 differs from the device for manufacturing the display panel described with reference to FIGS. 14 to 17 in that the reflective member 330 is embedded within the first light transmitting member 351. Descriptions overlapping with the embodiments of FIGS. 14 to 17 will be omitted.

Referring to FIG. 21, the reflective member 330 may be disposed within the first light transmitting member 351 to change the reflection path of the laser light applied from the laser emission portion 500. For example, the reflective member 330 may be embedded in an outer area of the first light transmitting member 351 corresponding to the non-display area NDA, which is an outer area of the display substrate 20, except for the display area DPA of the display substrate 20 where the plurality of light emitting elements LE are arranged.

In an embodiment, the reflective member 330 may be embedded in the first light transmitting member 351 and integrally formed with the first light transmitting member 351. The mirror may have a preset tilt in the direction in which the light absorbing member 340 is disposed.

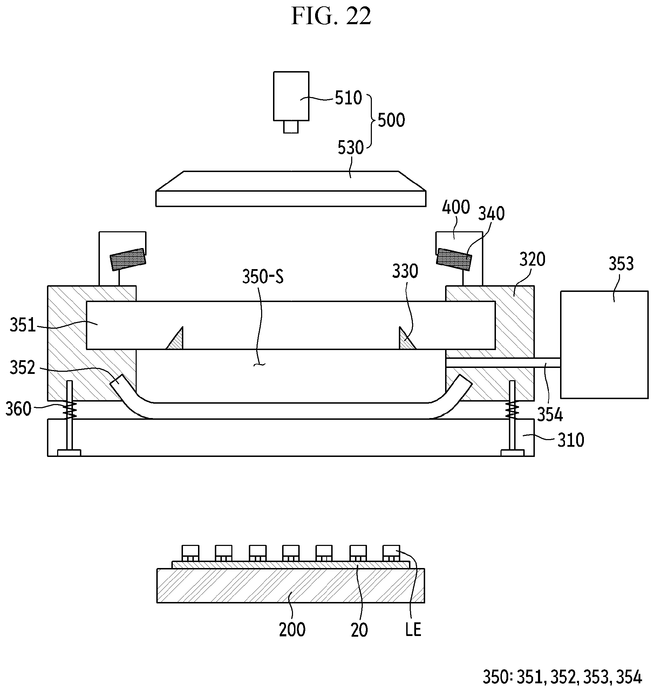

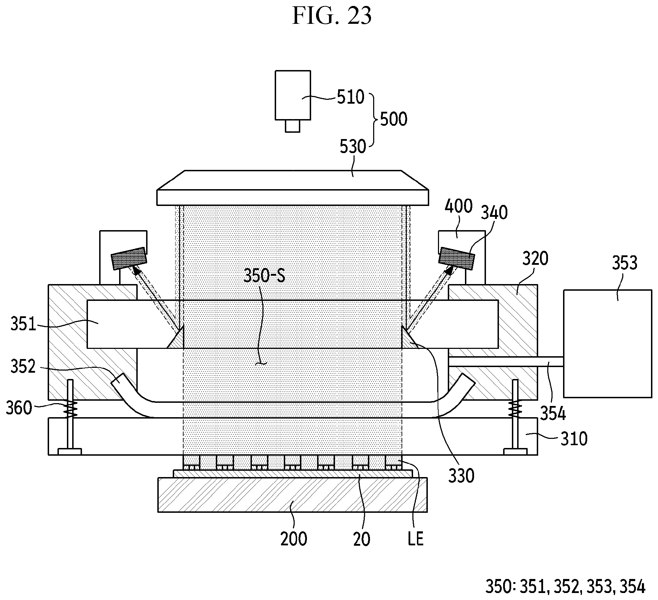

FIGS. 22 and 23 are cross-sectional views of one side illustrating a micro LED transfer method using the manufacturing device of FIG. 21.

Referring to FIG. 22, a plate transfer member 320 is coupled to the light transmitting plate 310 disposed on the front of the support portion 200 and may move the light transmitting plate 310 toward the display substrate 20 in proximity to the display substrate 20.

A gas pressure adjustment member 353 opens a gas valve to fill the closed space 350-S between the first light transmitting member 351 and the second light transmitting member 352 with gas through a gas conduit 354. As the gas is filled in the closed space 350-S, the pressure inside the closed space 350-S increases and expands in a downward direction, that is, in the direction toward the display substrate 20, generating a pressing force in the downward direction.

The second light transmitting member 352 expands downward by filling with gas, and a uniform pressure may be applied to the surface of the light emitting element LE on the display substrate 20.

Referring to FIG. 23, the laser emission portion 500 emits laser light in the direction of the light transmitting plate 310 on the lower surface. Here, the light emitted from the laser emission portion 500 penetrates one opening corresponding to the display area DPA of the display substrate 20 and is applied to the plurality of light emitting elements LE arranged on the display substrate 20.

In some embodiments, the laser light applied to the reflective member 330 corresponding to the non-display area NDA of the display substrate 20 is reflected toward the light absorbing member 340 by the tilt of the reflective member 330. Accordingly, among the laser light emitted from the laser emission portion 500, the light transmitted through one opening corresponding to the display area DPA of the display substrate 20 may be applied to the plurality of light emitting elements LE arranged on the display substrate 20. That is, for example, only the laser light that passes through the opening corresponding to the display area DPA may be applied to the plurality of light emitting elements LE arranged on the display substrate 20.

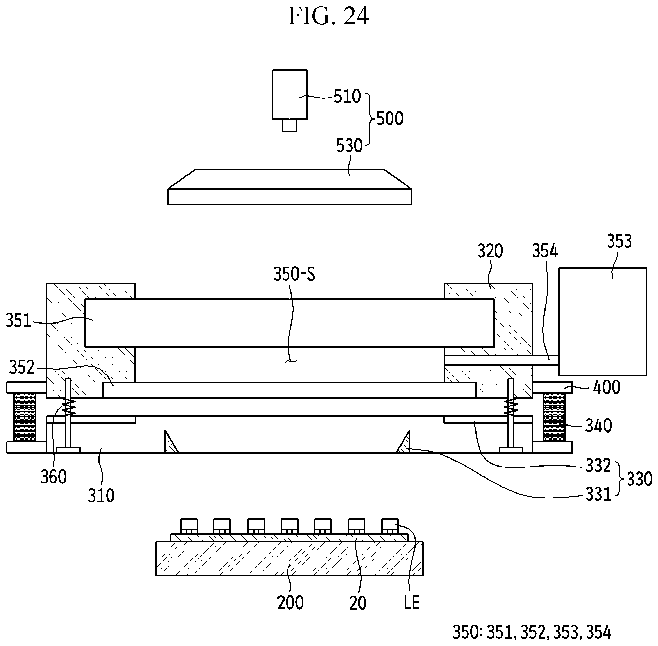

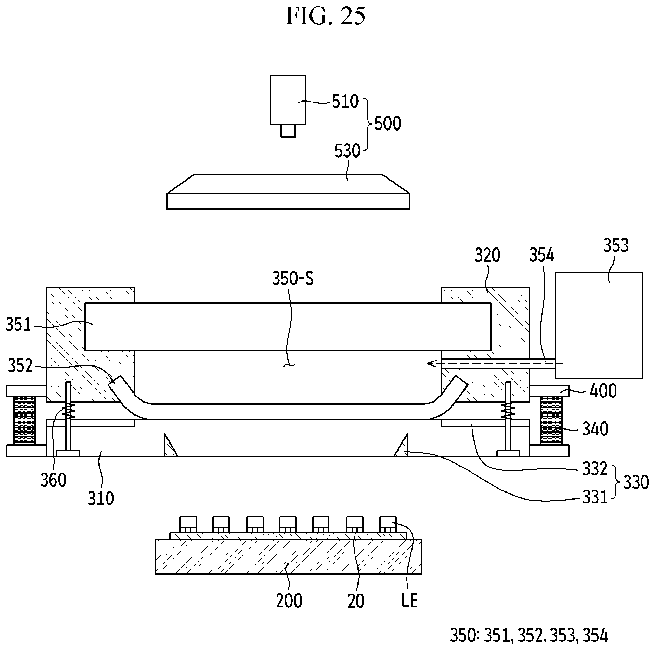

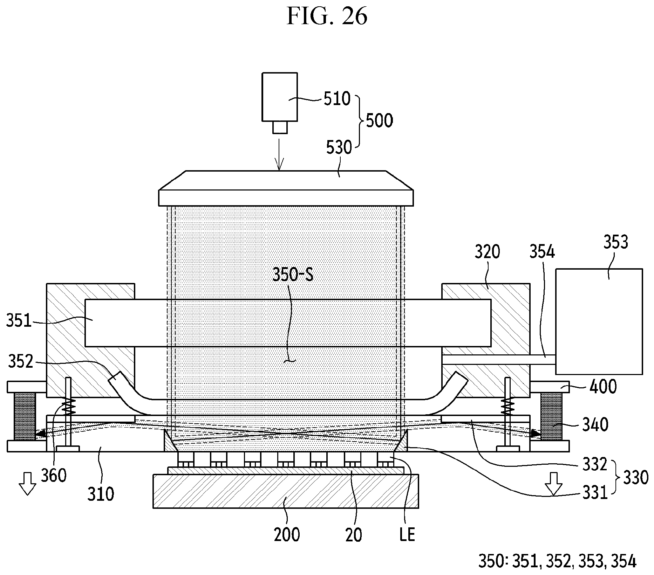

FIG. 24 is a side cross-sectional view schematically illustrating a display panel manufacturing device according to another embodiment. FIGS. 25 and 26 are cross-sectional views of one side illustrating a micro LED transfer method using the manufacturing device of FIG. 24.

Referring to FIG. 24, the device for manufacturing the display panel described with reference to FIGS. 14 to 17 differs from the device for manufacturing the display panel described with reference to FIGS. 14 to 17 in that the reflective member 330 includes a plurality of reflective members 331 and 332. Descriptions overlapping with the embodiments of FIGS. 14 to 17 will be omitted.

The reflective member 330 may include a first reflective member 331 and a second reflective member 332 embedded in the light transmitting plate 310. The location of the first reflective member 331 and the second reflective member 332 embedded in the light transmitting plate 310, and the reflection of the deployment laser light, are illustrated with reference to the embodiments illustrated in FIGS. 11 to 14.

The second reflective member 332 and the light absorbing member 340 do not overlap the laser light path emitted from the laser emission portion 500.

Referring to FIG. 25, the plate transfer member 320 is coupled to the light transmitting plate 310 disposed on the front of the support portion 200 and may move the light transmitting plate 310 in the direction toward the display substrate 20, such that the light transmitting plate 310 is moved closer to the display substrate 20. The movement of the plate transfer member 320 has been described in detail with reference to FIGS. 15 and 17, so overlapping descriptions will be omitted.

Referring to FIG. 26, the laser emission portion 500 emits laser light and irradiates the display substrate 20 with the laser light, through the light transmitting plate 310. Among the laser light emitted from the laser emission portion 500, the light transmitted through the openings of the first reflective member 331 may be applied to the plurality of light emitting elements LE arranged on the display substrate 20. In some embodiments, the laser light reflected by the second reflective member 332 proceeds to the light absorbing member 340 and is absorbed by the light absorbing member 340.

According to the display panel manufacturing device according to the embodiments, the laser beam emitted toward or incident surrounding areas other than the micro LED is reflected by the reflective member of the light transmitting plate, such that the laser beam is accurately applied to the micro LED (e.g., and not to undesired components), and the uniformity of the pressing force applied to the micro LED may be increased. Accordingly, manufacturing defects in the target substrate or display panel may be prevented and manufacturing efficiency may be improved.

In the descriptions of the method and processes herein, the operations may be performed in a different order than the order shown and/or described, or the operations may be performed in different orders or at different times. Certain operations may also be left out of the methods and processes, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

Although embodiments of the present disclosure have been described herein with reference to the attached drawings, a person skilled in the art to which the present disclosure pertains will understand that the present disclosure may be implemented in other specific forms without changing its technical idea or essential features as set out in the appended claims. Therefore, the embodiments described herein should be understood in all respects as illustrative and not restrictive.

## Claims

1. A device for manufacturing a display panel, the device comprising:
a support portion (200) on which a display substrate (20) is mounted;
a light transmitting plate (310) disposed on:
a front surface of the support portion (200),
a reflective member (330) disposed within the light transmitting plate (310), and
a light absorbing member (340) configured to absorb laser light reflected by the reflective member (330),
a pressing portion (300) configured to move the light transmitting plate (310) toward the display substrate (20) in association with pressing a plurality of light emitting elements (LE) arranged on the display substrate (20) with the light transmitting plate (310); and
a laser emission portion (500) disposed on a front side of the light transmitting plate (310) and configured to irradiate the display substrate (20) with the laser light through the light transmitting plate (310);
wherein the reflective member (330) comprises:
a first reflective member (331) defining an opening corresponding to a transmission area of the laser light, and
a second reflective member (332) configured to guide light reflected from the first reflective member (331) to the light absorbing member (340).

2. The device of claim 1, wherein:
the reflective member (330) further comprises a third reflective member (333) disposed between the second reflective member (332) and the light absorbing member (340), and
the third reflective member (333) is configured to reflect laser light reflected from the second reflective member (332) to the light absorbing member (340).

3. The device of claim 2, wherein the first reflective member (331), the second reflective member (332), and the third reflective member (333):
are embedded in an outer area of the light transmitting plate (310) corresponding to a non-display area (NDA), which is an outer area of the display substrate (20), excluding a display area (DPA) of the display substrate (20) on which the plurality of light emitting elements (LE) are arranged, and
are arranged in order from inside of the light transmitting plate (310) toward an outside of the light transmitting plate (310).

4. The device of claim 2 or 3, wherein:
the light transmitting plate (310) comprises a first inner surface (310a) and a second inner surface (310b) facing the first inner surface (310a),
the first reflective member (331) and the third reflective member (330, 331, 332, 333) are disposed on the first inner surface (310a), and
the second reflective member (332) is disposed on the second inner surface (310b).

5. The device of any one of the preceding claims, wherein:
the first reflective member (331) is formed in a shape of a triangular mountain having a triangular cross-section, and the triangular cross-section is formed as one of a right triangle, an equilateral triangle, and an isosceles triangle, and
one of front surfaces of the first reflective member (331) has a preset inclination in a direction in which the second reflective member (332) is disposed.

6. The device of any one of the preceding claims, wherein:
the light absorbing member (340) is disposed on a side of the light transmitting plate (310) and is disposed in a reflection path of the laser light; and/or
the opening is formed in an area corresponding to a non-display area (NDA), which is an outer area of the display substrate (20).

7. The device of any one of the preceding claims, wherein the pressing portion (300) comprises a plate transfer portion that is coupled to the light transmitting plate (310) and configured to move in a direction toward to the display substrate (20) or in an opposite direction away from the display substrate (20).

8. The device of claim 7, wherein the light transmitting plate (310):
is configured to transmit laser light incident the light transmitting plate (310), from:
a front of the light transmitting plate (310) to a back of the light transmitting plate (310) in a first direction; or
from the back to the front or back in a second direction opposite the first direction,
is formed in a form of a transparent or translucent flat plate,
is movable by the plate transfer portion in a direction toward to the display substrate (20) or in an opposite direction away from the display substrate (20), and
is movable in the direction toward the display substrate (20) by the plate (310) transfer portion in association with pressing a plurality of light emitting elements (LE) arranged on the display substrate (20) in the direction toward the display substrate (20).

9. A device for manufacturing a display panel, the device comprising:
a support portion (200) on which a display substrate (20) is mounted;
a pressing portion (300) comprising:
a light transmitting plate (310) disposed on a front surface of the support portion (200) or in front of the support portion (200),
a light absorbing member (340) configured to absorb laser light, and
a pressing member (350) configured to press the light transmitting plate (310); and
a laser emission portion (500) disposed in front of the pressing portion (300) and configured to emit laser light through the light transmitting plate (310) and irradiate the display substrate (20) with the laser light;
wherein the pressing member (350) comprises:
a first light transmitting member (351) disposed on the light transmitting plate (310);
a second light transmitting member (352) disposed on the light transmitting plate (310); and
a gas pressure adjustment portion configured to generate a pressing force on the light transmitting plate (310) by adjusting gas pressure in a closed space (350-S) formed between the first light transmitting member (351) and the second light transmitting member (352);
wherein:
the pressing portion (300) further comprises a reflective member (330) disposed within the light transmitting plate (310) and the light absorbing member (340) is configured to absorb laser light reflected by the reflective member (330), or
the pressing member (350) further comprises a reflective member (330) disposed within the light transmitting plate (310) and configured to reflect incident laser light to the light absorbing member (340).

10. The device of claim 9, wherein:
the first light transmitting member (351) is formed of a rigid material, and
the second light transmitting member (352) is formed of an elastic material; and/or
wherein the second light transmitting member (352) is arranged such that the second light transmitting member (352) overlaps the first light transmitting member (351) in a thickness direction.

11. The device of claim 9 or 10, wherein the reflective member (330) comprises:
a first reflective member (331) defining an opening corresponding to a transmission area of the laser light, and
a second reflective member (332) configured to guide light reflected from the first reflective member (331) to the light absorbing member (340).

12. The device of any one of claims 9 to 11, further comprising:
a gas conduit (354) connected between the gas pressure adjustment portion and the closed space (350-S); and/or
a buffering member disposed between the light transmitting plate (310) and the pressing member (350).

13. The device of any one of claims 9 to 12, wherein:
the reflective member (330) is formed in a shape of a triangular mountain having a triangular cross-section, and the triangular cross-section is formed as one of a right triangle, an equilateral triangle, and an isosceles triangle, and
a front surface of the reflective member (330) is inclined at a preset inclination in a direction in which the light absorbing member (340) is disposed.

14. The device of any one of claims 9 to 13, wherein the reflective member (330) is attached to or mounted on an outer area of the light transmitting plate (310) corresponding to a non-display area (NDA), which is an outer area of the display substrate (20), excluding a display area (DPA) of the display substrate (20) where a plurality of light emitting elements (LE) are arranged.

15. The device of any one of claims 9 to 14, wherein:
the light absorbing member (340) is disposed between the laser emission portion (500), and the pressing portion (300) or the first light transmitting member (351), and does not overlap a light path associated with the laser light emitted by the laser emission portion (500); and/or
the light absorbing member (340) is disposed in the closed space (350-S) and does not overlap a light path associated with the laser light emitted by the laser emission portion (500).
